# EUROPEAN PATENT APPLICATION

(11) **EP 4 723 177 A1**
(43) Date of publication of application: **08.04.2026**
(21) Application number: 24815630.9
(22) Date of filing: 31.05.2024
(51) Int. Cl.: H01L 33/32, H01L 21/20

(54) **GROUP III NITRIDE LIGHT-EMITTING DEVICE**

(30) Priority: 01.06.2023 JP 2023091229
(71) Applicant: Mie University, Tsu-shi, Mie 514-8507 (JP)
(72) Inventor: MIYAKE, Hideto, Tsu-shi, Mie 514-8507 (JP); UESUGI, Kenjiro, Tsu-shi, Mie 514-8507 (JP); NAKAMURA, Takao, Tsu-shi, Mie 514-8507 (JP); KOJIMA, Kazunobu, Suita-shi, Osaka 565-0871 (JP); ICHIKAWA, Shuhei, Suita-shi, Osaka 565-0871 (JP)
(74) Representative: Acapo Onsagers AS
(86) International application number: PCT/JP2024/020108
(87) International publication number: WO 2024/248151

(57) **Abstract**

The light-emitting device includes: a Group III nitride semiconductor layer containing Al as a constituent element; an electron blocking layer containing Al as a constituent element; and an Al-containing blocking layer provided between the electron blocking layer and the Group III nitride semiconductor layer. The device is configured to emit light having a peak wavelength in the deep ultraviolet region of 240 nm or shorter and 206 nm or longer. The device further includes an active layer comprising an Al_{Y}Ga_{1-Y}N layer (where the Al composition Y is greater than zero) and a base member having a primary surface composed of Al_{X}Ga_{1-X} N (where X is greater than 0 and less than 1), the primary surface carrying the Group III nitride semiconductor layer, the active layer, and the electron blocking layer. In this configuration, the Al composition G in the active layer is equal to or greater than Y and less than (Y + 0.04), and the difference between the maximum Al composition in the electron blocking layer and the Al composition in the active layer is 0.18 or greater.

## Description

### Technical Field

The present disclosure relates to a Group III nitride light-emitting device.

### Background Art

Non-Patent Document 1 discloses a light-emitting device having a single-crystal aluminum nitride substrate. Non-Patent Documents 2 and 3 disclose light-emitting devices each having an aluminum nitride template.

### Prior Art Document

### Non-patent Document

Non-patent document 1: Hirotsugu Kobayashi et. al., "Milliwatt-power sub-230-nm AlGaN LEDs with > 1500 h lifetime on a single-crystal AlN substrate with many quantum wells for effective carrier injection", Appl. Phys. Lett. 122, 101103 (2023); doi: 10.1063/5.0139970
Non-patent document 2: Masafumi Jo, et. al., "Milliwatt-power far-UVC AlGaN LEDs on sapphire substrates", Appl. Phys. Lett. 120, 211105 (2022); doi: 10.1063/5.0088454
Non-patent document 3: A. Knauer, et. al., "Strain induced power enhancement of far-UVC LEDs on high temperature annealed AlN templates"
Non-patent document 4: H. Amano et al., J. Phys. D: Appli. Phys. 53, 50 (2020)

### SUMMARY OF INVENTION

### Technical Problem

Deep ultraviolet light having a wavelength of 230 nm or less, unlike ultraviolet light in the 265 nm band that has conventionally been used for sterilization, is substantially absorbed by the stratum corneum of the epidermis of mammals such as humans. Accordingly, such light does not adversely affect DNA inside cells. Therefore, there is a demand for a novel sterilization technology that does not cause such adverse biological effects.

In nitride semiconductor light-emitting devices configured to generate light in the deep ultraviolet region, it has been found by the inventors that the barrier height of an electron blocking layer is relatively lower than that of an active layer configured to generate ultraviolet light of a longer wavelength. Such a relative reduction may not sufficiently suppress leakage of electrons from the active layer. The maximum barrier that can be provided in a nitride semiconductor light-emitting device is aluminum nitride (AlN). Exceeding this material limitation would require the development of a material or structure capable of providing a barrier higher than the band gap of AlN.

Accordingly, there is a demand for improving the performance of nitride semiconductor light-emitting devices that generate light in the deep ultraviolet region. In order to meet this demand, a solution other than the development of new materials is required.

It is an object of the present disclosure to provide a group III nitride light-emitting device that is capable of suppressing a decrease in external quantum efficiency resulting from a reduction in the band offset between an active layer and an electron blocking layer.

### Solution to Problem

One aspect according to a Group III nitride light-emitting devices comprises: a Group III nitride semiconductor layer containing Al as a constituent element; an electron blocking layer containing Al as a constituent element; an active layer disposed between the electron blocking layer and the Group III nitride semiconductor layer so as to generate light having a peak wavelength in a deep ultraviolet wavelength region of 240 nm or less and 206 nm or more, the active layer including an Al_{Y}G_{1-Y}N layer, where Y is an Al composition, and Y is greater than zero; and a base member having a primary surface containing A₁XG_{1-X}X, the Group III nitride semiconductor layer, the active layer, and the electron blocking layer being mounted on the primary surface, wherein X is greater than 0 and 1 or less, wherein the active layer has an Al composition G of equal to or greater than Y and less than (Y + 0.04); and wherein a composition difference between a maximum Al composition of the electron blocking layer and an Al composition of the active layer is 0.18 or more.

### Advantageous Effects of Invention

According to the foregoing aspect, a group III nitride light-emitting device can be provided that suppresses a decrease in external quantum efficiency resulting from a reduction in the band offset between an active layer and an electron blocking layer. Furthermore, the foregoing aspect addresses the problem of a relative decrease in the electron barrier.

### BRIEF DESCRIPTION OF DRAWINGS

FIG. 1 is a schematic diagram illustrating a light-emitting device according to an embodiment of the present disclosure.
FIG. 2 is a diagram illustrating the structure of a light-emitting device according to the present embodiment.
FIG. 3 is a schematic diagram illustrating a conduction band structure and an aluminum composition profile of an active layer of the light-emitting device shown in FIG. 1.
FIG. 4 is a schematic diagram illustrating main steps of a method for fabricating a light-emitting device according to the present embodiment.
FIG. 5 is a schematic diagram illustrating major steps of a method for fabricating a light-emitting device according to the present embodiment.
FIG. 6 is a schematic diagram illustrating major steps of a method for fabricating a light-emitting device according to the present embodiment.
FIG. 7 is a schematic diagram illustrating major steps of a method for fabricating a light-emitting device according to the present embodiment.
FIG. 8 is a diagram illustrating an Al composition profile in the active layer and semiconductor regions adjacent to the light-emitting device shown in FIGS. 1 and 3.
FIG. 9 is a flow chart illustrating major steps of a method for fabricating a nitride semiconductor light-emitting device according to an embodiment.
FIG. 10 is a diagram showing simulation results illustrating the relationship between current injection efficiency (CIE) and emission wavelength.
FIG. 11 is a diagram showing simulation results illustrating the relationship between leakage current and emission wavelength.
FIG. 12 is a diagram illustrating the structure of a light-emitting diode (LED).
FIG. 13 is a diagram showing a reciprocal lattice mapping image of the LED structure shown in FIG. 12 obtained by X-ray diffraction (XRD).
FIG. 14 is a diagram showing an X-ray diffraction (XRD) image of an n-type semiconductor layer (Al_{0.86}Ga_{0.14}N) of the LED structure shown in FIG. 12.
FIG. 15 is a diagram showing diffraction peak images of the (0004) and (20-22) planes of an AlN single crystal on a sapphire substrate.
FIG. 16 is a diagram showing electroluminescence (EL) of an LED structure.
FIG. 17 is a diagram showing external quantum efficiency (EQE) of an LED structure.
FIG. 18 is a diagram showing the relationship between emission wavelength and external quantum efficiency (EQE) of an LED structure.
FIG. 19 is a diagram showing the relationship between injection current into an LED structure and external quantum efficiency (EQE).
FIG. 20 is a diagram showing EL spectra of assembled devices (DEV_A, DEV_B).
FIG. 21 is a diagram showing the injection current dependence of optical output and external quantum efficiency of an assembled device (DEV_A, emission wavelength 230 nm).
FIG. 22 is a diagram showing the injection current dependence of optical output and external quantum efficiency of an assembled device (DEV_B, emission wavelength 236 nm).
FIG. 23A is a diagram showing an area-averaged CL spectrum at room temperature.
FIG. 23B is a diagram showing an atomic force microscope (AFM) image.
FIG. 23C is a diagram showing a scanning electron microscope (SEM) image.
FIG. 24 is a diagram showing surface AFM images of a light-emitting layer of a multiple quantum well structure and a bulk film.
FIG. 25 is a diagram showing CL images of a light-emitting layer of a multiple quantum well structure and a bulk film.
FIG. 26 is a diagram showing CL peak energy maps of a light-emitting layer having a multiple quantum well structure and a bulk film.
FIG. 27 is a diagram showing an NBE integrated CL intensity map and a peak energy map of a bulk film light-emitting layer measured at room temperature.
FIG. 28 is a diagram showing surface morphology by an AFM image.
FIG. 29 is a diagram showing the relationship between integrated CL intensity and photon energy.
FIG. 30 is a diagram showing the relationship between integrated CL intensity and photon energy measured at 79 K and at room temperature.

### DESCRIPTION OF EMBODIMENTS

The embodiments of the present disclosure will now be described with reference to the drawings. Identical or corresponding components are denoted by the same or similar reference numerals, and repeated descriptions will be omitted where appropriate.

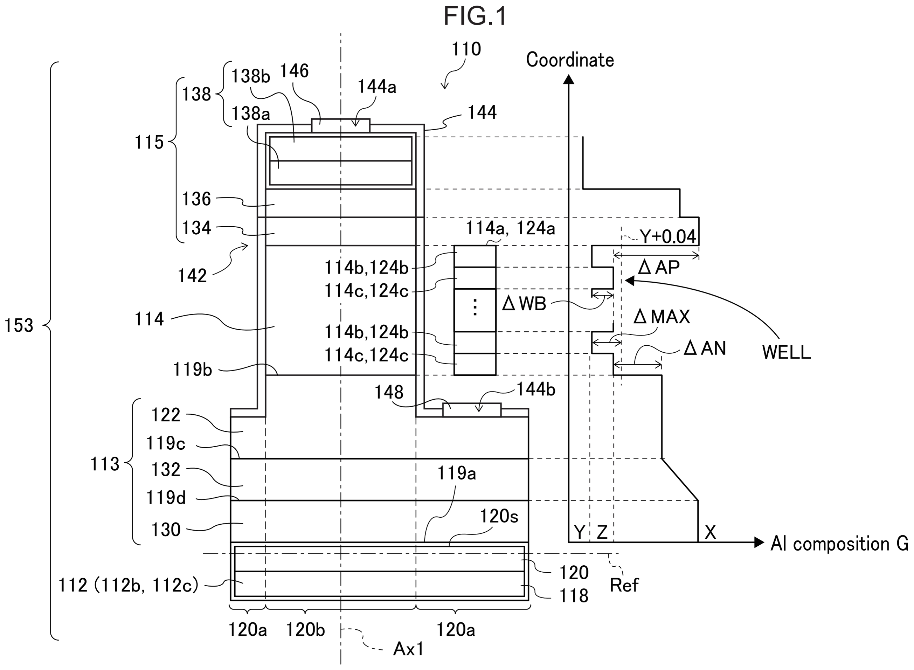

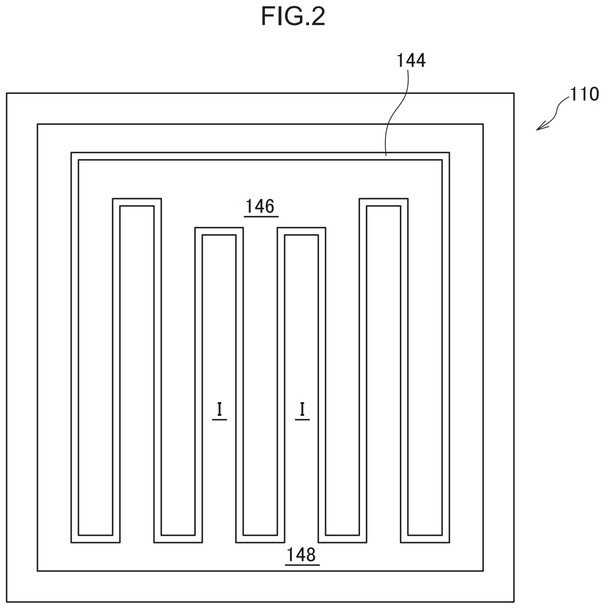

FIG. 1 is a schematic view illustrating a light-emitting device according to an embodiment of the present disclosure. FIG. 2 is a diagram illustrating the structure of an exemplary light-emitting device according to an embodiment of the present disclosure. FIG. 1 illustrates a cross-sectional view taken along line I-I of FIG. 2.

The light-emitting device can be, for example, a semiconductor element that includes an active layer for light emission provided with a group III nitride, such as a light-emitting diode, a semiconductor laser, or an electron-beam-excited light source. In the following description, an exemplary light-emitting device 110 has the structure of a light-emitting diode.

The light-emitting device 110 includes a base member 112 and an active layer 114, and further includes a first nitride semiconductor layer 122 containing Al as a constituent element and an electron blocking layer 134 containing Al as a constituent element. The first nitride semiconductor layer 122 is included in a lower group III nitride stack 113, and the electron blocking layer 134 is included in an upper group III nitride stack 115. The first nitride semiconductor layer 122 may comprise a group III nitride semiconductor layer. The active layer 114 is disposed between the first nitride semiconductor layer 122 and the electron blocking layer 134 to form, for example, a potential well. Carriers are injected into this potential well from an n-type semiconductor layer in the lower group III nitride stack 113 and a p-type semiconductor layer in the upper group III nitride stack 115. The n-type semiconductor layer and the p-type semiconductor layer may comprise group III nitrides containing respective dopants.

The first nitride semiconductor layer 122, the active layer 114, and the electron blocking layer 134 are provided on a base member 112. The base member 112 is made of, for example, Al_{X}Ga_{1-X}N (where 0 < X ≤ 1) and has a primary surface on which the first nitride semiconductor layer 122 of n-type is formed. The base member 112, the first nitride semiconductor layer 122, the active layer 114, and the electron blocking layer 134 are arranged along an axis Ax1 extending in a direction intersecting the primary surface of the base member 112. The base member 112 may include, for example, a nitride single-crystal support 112b containing aluminum as a constituent element, or a template member 112c.

The single-crystal support 112b may be, for example, Al_{X}Ga_{1-X}N. The substrate has a primary surface containing nitrogen and may be, for example, a bulk AlN single crystal (where X = 1, hexagonal crystal system). The primary surface of the bulk AlN single crystal, for example a bulk AlN single-crystal substrate, may be a c-plane and may have an off-axis angle of 0.5 degrees in the m-axis direction.

In FIG. 1, the template member 112c is illustrated as an exemplary base member 112. The template member 112c includes a support 118 and a template layer 120. The support 118 has a primary surface 118a made of a material different from a group III nitride. The template layer 120 is formed of Al_{X}Ga_{1-X}N (where X is greater than 0 and equal to or less than 1) and covers the primary surface 118a of the support 118. For example, the full width at half maximum (FWHM) of the X-ray rocking curve of the (10-12) plane of the template layer 120 may be 1000 arcsec or less, and the template layer 120 contains compressive strain. This compressive strain serves as a source of strain applied to the active layer 114. The thickness of the template layer 120 may be, for example, in the range of 100 nm to 2000 nm, such as about 500 nm. The Al_{X}Ga_{1-X}N of the template layer 120 may be AlN (X = 1), in which case the template layer 120 is AlN containing compressive strain.

Exemplary substrates 118 may include at least one material selected from the group consisting of carbon, boron nitride (BN), aluminum oxide (sapphire), ceramics, silicon carbide, refractory metals, zirconia, tantalum carbide (TaC), and ScAlMgO₄.

The template member 112c, the lower group III nitride stack 113, the active layer 114, and the upper group III nitride stack 115 are arranged along an axis Ax1 that intersects the primary surface 120s of the template layer 120.

The active layer 114 is disposed on the base member 112, which may be either the single-crystal support 112b or the template member 112c, and is configured to generate light having a peak wavelength (i.e., the wavelength corresponding to the maximum light intensity) in the deep ultraviolet region of 240 nm or less. The peak wavelength of the light emitted from the active layer 114 may be 206 nm or more. The active layer 114 may include at least one Al_{Y}Ga_{1-Y}N layer (where Y represents the Al composition, and Y is greater than 0). The Al_{Y}Ga_{1-Y}N layer constitutes a light-emitting layer associated with optical transitions occurring in the active layer 114. Optical transitions resulting from carrier recombination may occur in at least a portion of this light-emitting layer. In particular, the active layer 114 may have a structure including either a single film or a multilayer film, the structure being configured to generate light having a peak wavelength in the deep ultraviolet region of 240 nm or less and 206 nm or more.

Further, the exemplary active layer 114 may comprise a group III nitride containing aluminum and gallium as group III constituent elements, such as at least one of ternary AlGaN and quaternary InAlGaN, and may contain compressive strain. The active layer 114 may have, for example, a structure including a single film in a single well (e.g., a bulk light-emitting layer), a stacked structure including multiple films in a single well, or a multiple quantum well (MQW) structure.

The upper group III nitride stack 115 includes a p-type group III nitride semiconductor region configured to supply carriers (e.g., holes) to the active layer 114, and the lower group III nitride stack 113 includes an n-type group III nitride semiconductor region configured to supply carriers (e.g., electrons) to the active layer 114. Specifically, the p-type group III nitride semiconductor region may be formed by providing a p-type dopant in at least a portion of the upper group III nitride stack 115, and the n-type group III nitride semiconductor region may be formed by providing an n-type dopant in at least a portion of the lower group III nitride stack 113.

The upper group III nitride stack 115 may include a heterobarrier layer (e.g., an electron blocking layer 134) configured to provide a barrier against carriers (e.g., electrons) injected from the lower group III nitride stack 113. The electron blocking layer 134 may have either a substantially uniform Al composition or a compositionally graded Al composition. The lower group III nitride stack 113 may also include a heterobarrier layer (e.g., a first nitride semiconductor layer 122) configured to provide a barrier against carriers (e.g., holes) injected from the upper group III nitride stack 115. The first nitride semiconductor layer 122 may have either a substantially uniform Al composition or a compositionally graded Al composition. The exemplary active layer 114 forms a junction with the first nitride semiconductor layer 122 and the electron blocking layer 134.

The active layer 114 has an Al composition G, which is represented by a profile (G). The profile (G) of the Al composition is defined as a function of coordinates along an axis Ax1 extending from the first nitride semiconductor layer 122 to the electron blocking layer 134. The profile (G) may represent a substantially uniform Al composition, or may represent periodic or aperiodic variations in the Al composition among multiple semiconductor layers constituting the active layer 114.

The active layer 114 may satisfy a condition such that the Al composition G in the active layer 114 is equal to or greater than Y and less than (Y + 0.04) (i.e., less than ΔMAX).

Setting an upper limit on the Al composition G of the active layer 114 makes it possible to reduce the average number of Al atoms per unit volume (Al atom density) throughout the active layer 114. Reducing the Al atom density is effective in avoiding an increase in the electrical resistance of the active layer 114 and in preventing a reduction in the relative heterobarrier at the electron energy level associated with optical transitions in the active layer 114. Specifically, in a case where the thickness of the active layer 114 is fixed, a bulk light-emitting layer can have a lower Al atom density than that of the active layer 114 having a stacked structure of multiple films in a single well or a multiple quantum well structure. Accordingly, the bulk light-emitting layer can effectively utilize the heterobarrier for electrons (i.e., the barrier provided by the electron blocking layer 134) and can prevent an increase in the electrical resistance of current flowing through the active layer 114.

With respect to the conditions associated with the heterobarrier layer of the upper Group III nitride stack 115 (e.g., the electron blocking layer 134) and the heterobarrier layer of the lower Group III nitride stack 113 (e.g., the first nitride semiconductor layer 122), the active layer 114 may satisfy at least one of the following conditions (a) to (c):
(a) When the electron blocking layer 134 has a compositionally graded structure or a uniform composition structure, the minimum value (ΔAP) of the composition difference (ΔAP or ΔAP + ΔWB) between the maximum Al composition in the electron blocking layer 134 and the Al composition of the active layer 114 is 0.18 or more.
(b) When the first nitride semiconductor layer 122 has a compositionally graded structure or a uniform composition structure, the minimum value (ΔAN) of the composition difference (ΔAN or ΔAN + ΔWB) between the maximum Al composition in the first nitride semiconductor layer 122 and the Al composition of the active layer 114 is 0.06 or more.
(c) The Al composition G in the active layer 114 is equal to or greater than Y and less than (Y + 0.04).

Furthermore, with respect to the conditions associated with the heterobarrier layer of the upper Group III nitride stack 115 and the heterobarrier layer of the lower Group III nitride stack 113, the bulk light-emitting layer (ΔWB = 0) in the active layer 114 may satisfy at least one of the following conditions (a) to (c):
(a) When the electron blocking layer 134 has a compositionally graded structure or a uniform composition structure, the minimum value (ΔAP + ΔWB, where ΔWB = 0) of the composition difference between the maximum Al composition in the electron blocking layer 134 and the Al composition (Y) of the active layer 114 is 0.18 or more.
(b) When the first nitride semiconductor layer 122 has a compositionally graded structure or a uniform composition structure, the minimum value (ΔAN + ΔWB, where ΔWB = 0) of the composition difference between the maximum Al composition in the first nitride semiconductor layer 122 and the Al composition (Y) of the active layer 114 is 0.06 or more.
(c) The Al composition G in the active layer 114 is equal to or greater than Y and less than (Y + 0.04).

In addition, the difference between the Al composition (Y) of the active layer 114 and the Al composition of the electron blocking layer 134 may be 0.18 or more. The difference between the Al composition (Y) of the active layer 114 and the Al composition of the first nitride semiconductor layer 122 may be 0.06 or more. The Al composition Y of the bulk light-emitting layer may, for example, fall within a range from 0.73 to 1.00. The thickness of the bulk light-emitting layer may, for example, fall within a range from 10 nm to 100 nm.

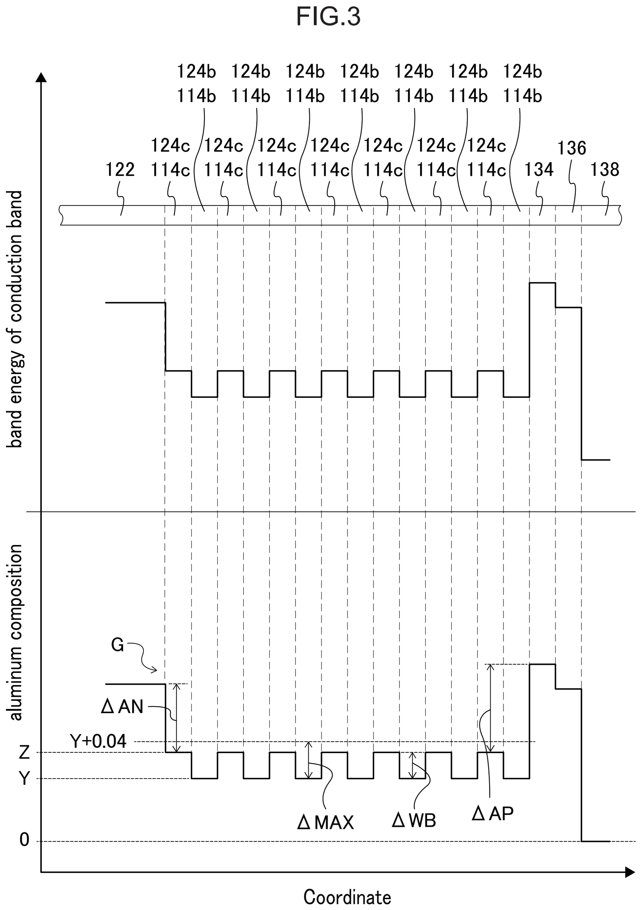

FIG. 3 is a diagram illustrating an exemplary conduction band structure and an exemplary aluminum composition profile of the active layer in the light-emitting device shown in FIG. 1.

As shown in FIG. 3, the active layer 114 has an Al composition G, which is represented by a profile (G). In FIG. 3, the profile (G) is expressed as a function of a coordinate defined along the axis Ax1. The Al composition G in the active layer 114 may be equal to or greater than Y and less than (Y + 0.04). The Al composition G in the active layer 114 may, for example, be less than or equal to (Y + 0.035), (Y + 0.03), (Y + 0.02), or (Y + 0.01).

Setting an upper limit on the Al composition G of the active layer 114 may suppress heat generation due to increased resistance of the active layer 114, i.e., self-heating, and may separate the electronic energy level associated with optical transitions in the active layer 114 from the electronic energy level of the heterobarrier of the electron blocking layer 134. Furthermore, setting the upper limit on the Al composition G of the active layer 114 may relatively increase the heterobarrier of the electron blocking layer 134 against electrons in the active layer 114 without changing the material of the electron blocking layer 134 or the structure of the heterobarrier, thereby reducing the possibility of electron leakage from the active layer 114. In addition, setting the upper limit on the Al composition G of the active layer 114 may relatively increase the heterobarrier against holes in the active layer 114 without changing the material of the first nitride semiconductor layer 122 or the structure of the heterobarrier, thereby making it possible to reduce leakage of holes from the active layer 114.

The active layer 114 may include a stacked structure 124a, such as a multiple quantum well structure 114a. The stacked structure 124a may include multiple semiconductor layers (124b, 124c) having different Al compositions. Specifically, the stacked structure 124a includes at least one first semiconductor layer 124b having the smallest Al composition among the semiconductor layers of the stacked structure 124a, and at least one second semiconductor layer 124c having the largest Al composition among the semiconductor layers of the stacked structure 124a. The stacked structure 124a may further include, for example, at least one third semiconductor layer having an Al composition different from those of the first semiconductor layer 124b and the second semiconductor layer 124c. The multiple semiconductor layers (124b, 124c) may have different thicknesses or may have substantially the same thickness.

The first semiconductor layer 124b and the second semiconductor layer 124c are arranged in a direction from one of the first nitride semiconductor layer 122 and the electron blocking layer 134 toward the other so as to form a profile of the Al composition G in the active layer 114. For example, the first semiconductor layer 124b comprises a nitride containing Ga and Al as group III constituent elements, and may specifically include an Al_{Y}Ga_{1-Y}N layer (where Y represents the Al composition of the active layer 114). The second semiconductor layer 124c includes a nitride containing Ga and Al as group III constituent elements, and may include, for example, an Al_{Z}Ga_{1-Z}N layer (where Z represents the Al composition, and Z is greater than Y and less than 1). The group III nitride of the second semiconductor layer 124c has a larger bandgap than that of the group III nitride of the first semiconductor layer 124b.

The difference (ΔAP) between the Al composition of the second semiconductor layer 124c and the Al composition of the electron blocking layer 134 is greater than the difference (ΔWB) between the Al composition of the first semiconductor layer 124b and the Al composition of the second semiconductor layer 124c.

In the exemplary stacked structure 124a, the Al composition of the first nitride semiconductor layer 122 is greater than that of the second semiconductor layer 124c. The difference (ΔAN) in Al composition between the first nitride semiconductor layer 122 and the second semiconductor layer 124c is greater than the difference (ΔWB) in Al composition between the first semiconductor layer 124b and the second semiconductor layer 124c.

The Al composition G in the exemplary stacked structure 124a may be equal to or greater than Y and less than (Y + 0.04) (i.e., less than ΔMAX). The minimum value of the Al composition G may be Y. Setting an upper limit on the Al composition of the stacked structure 124a, as described above, may reduce carrier leakage and self-heating in the active layer 114.

Specifically, the difference (ΔMAX) in Al composition between the second semiconductor layer 124c and the first semiconductor layer 124b may be less than 0.04. Alternatively, the difference (ΔMAX) in Al composition between the second semiconductor layer 124c and the first semiconductor layer 124b may be 0.035 or less. Alternatively, the difference (ΔMAX) in Al composition between the second semiconductor layer 124c and the first semiconductor layer 124b may be 0.03 or less, 0.02 or less, or 0.01 or less.

Reducing the Al composition of a semiconductor layer having a high Al content, for example, the second semiconductor layer 124c, may improve the external quantum efficiency. In the stacked structure 124a of the active layer 114, the Al composition of the second semiconductor layer 124c may be less than 0.823 and greater than Y. The Al composition of the second semiconductor layer 124c may be 0.801 or less. The Al composition of the first semiconductor layer 124b may also be 0.801 or less.

The difference between the Al composition of the second semiconductor layer 124c and the maximum Al composition of the electron blocking layer 134 may be greater than the difference between the Al compositions of the first and second semiconductor layers 124b and 124c. The difference between the Al composition of the first nitride semiconductor layer 122 and that of the second semiconductor layer 124c may also be greater than the difference between the Al compositions of the first and second semiconductor layers 124b and 124c.

The Al composition, film thickness, and arrangement of the first semiconductor layer 124b and the second semiconductor layer 124c may be specified such that a multiple quantum well structure 114a is not formed in the active layer 114.

However, the Al composition, film thickness, and arrangement of the first semiconductor layer 124b and the second semiconductor layer 124c may be specified such that a multiple quantum well structure 114a is formed in the active layer 114. In this stacked structure 124a, the first semiconductor layer 124b functions as a well layer, and the second semiconductor layer 124c functions as a barrier layer.

Next, the multiple quantum well structure will be described with reference to the exemplary conduction band structure and the aluminum composition profile (G) of the active layer 114 shown in FIG. 3. As described above, the structure of the active layer 114 is not limited to a single quantum well structure or a multiple quantum well structure.

The multiple quantum well structure 114a of the active layer 114 includes a plurality of well layers 114b and one or more barrier layers 114c. Each well layer 114b may comprise an Al_{Y}Ga_{1-Y}N layer (Y being the Al composition, where 0 < Y < 1). Each barrier layer 114c may comprise an Al_{Z}Ga_{1-Z}N layer (Z being the Al composition, where Z > Y and Z < 1).
The Group III nitride of the barrier layer 114c has a larger bandgap than that of the well layer 114b. The minimum Al composition of the electron blocking layer 134 may be equal to or greater than the Al composition of the barrier layer 114c. For example, the composition difference (ΔAP) between the Al composition of the barrier layer 114c closest to the electron blocking layer 134 and the Al composition of the electron blocking layer 134 may be greater than the composition difference (ΔWB) between the Al composition of the barrier layer 114c and that of the well layer 114b.

The Al composition of the first nitride semiconductor layer 122 is greater than that of the barrier layer 114c. For example, the composition difference (ΔAN) between the Al composition of the barrier layer 114c closest to the first nitride semiconductor layer 122 and the Al composition of the first nitride semiconductor layer 122 may be greater than the composition difference (ΔWB) between the Al composition of the well layer 114b and that of the barrier layer 114c.

The profile (G) of the Al composition in the exemplary multiple quantum well structure 114a may be equal to or greater than Y and less than (Y + 0.04) (i.e., less than ΔMAX). Setting an upper limit on the Al composition of the multiple quantum well structure 114a may reduce carrier leakage from the active layer 114 and suppress self-heating of the active layer 114.

Specifically, the multiple quantum well structure 114a, in which the Al composition difference (ΔWB) between the barrier layer 114c and the well layer 114b is less than 0.04, may have the film thicknesses of the well layer 114b and the barrier layer 114c within the following ranges:
Well layer 114b: 1 to 5 nm (e.g., 2 nm).
Barrier layer 114c: 2 to 20 nm (e.g., 3 nm).

Furthermore, the multiple quantum well structure 114a, in which the difference in Al composition between the barrier layer 114c and the well layer 114b is 0.035 or less, may have the film thicknesses of the well layer 114b and the barrier layer 114c within the following ranges:
Well layer 114b: 0.5 to 5 nm.
Barrier layer 114c: 2 to 20 nm.

The multiple quantum well structure 114a, in which the difference in Al composition between the barrier layer 114c and the well layer 114b is 0.030 or less, may have the film thicknesses of the well layer 114b and the barrier layer 114c within the following ranges:
Well layer 114b: 0.5 to 5 nm.
Barrier layer 114c: 2 to 10 nm.

The multiple quantum well structure 114a, in which the difference in Al composition between the barrier layer 114c and the well layer 114b is 0.020 or less, may have the film thicknesses of the well layer 114b and the barrier layer 114c within the following ranges:
Well layer 114b: 0.5 to 5 nm.
Barrier layer 114c: 2 to 10 nm.

The multiple quantum well structure 114a, in which the difference in Al composition between the barrier layer 114c and the well layer 114b is 0.010 or less, may have the film thicknesses of the well layer 114b and the barrier layer 114c within the following ranges:
Well layer 114b: 0.5 to 5 nm.
Barrier layer 114c: 2 to 5 nm.

Reducing the Al composition of a semiconductor layer having a high Al composition in the active layer 114, for example, the barrier layer 114c, may improve the external quantum efficiency. In the multiple quantum well structure 114a of the active layer 114, the Al composition of the barrier layer 114c may be less than 0.823 and greater than Y. The Al composition of the barrier layer 114c may also be equal to or less than 0.801. The Al composition Y of the well layer 114b may be equal to or less than 0.801.

The average Al composition in the active layer 114 may be reduced to prevent an increase in the electrical resistance of the active layer 114. In addition, reducing the average Al composition in the active layer 114 may suppress the generation of group III vacancies, thereby decreasing the concentration of non-radiative recombination centers.

As described with reference to FIGS. 1 to 3, the active layer 114, which may include at least one of a bulk light-emitting layer, the stacked structure 124a, or the multiple quantum well structure 114a, may satisfy at least one of the following conditions (a) to (c) with respect to its Al composition:
(a) The minimum difference between the maximum Al composition of the electron blocking layer 134 and the Al composition of the active layer 114 is 0.18 or greater.
(b) The minimum difference between the Al composition of the first nitride semiconductor layer 122 and the Al composition of the active layer 114 is 0.06 or greater.
(c) The Al composition G of the active layer 114 is equal to or greater than Y and less than (Y + 0.04).

Continuing with reference to FIG. 1, the upper Group III nitride stack 115 and the lower Group III nitride stack 113 will now be described in detail.

The upper Group III nitride stack 115 is provided on the template member 112c such that the active layer 114 is disposed between the upper Group III nitride stack 115 and the template member 112c. The upper Group III nitride stack 115 may include one or more Group III nitride semiconductor layers (e.g., AlN, AlGaN, GaN, or InAlGaN), each containing at least one of Al and Ga as Group III constituent elements.

The upper Group III nitride stack 115 may include an electron blocking layer 134, a p-type semiconductor layer 136, and a p-type contact layer 138. Specifically, the exemplary upper Group III nitride stack 115 may include the following semiconductor structures.

The upper Group III nitride stack 115 may include an electron blocking layer 134, a p-type semiconductor layer 136, and a p-type contact layer 138. Specifically, the exemplary upper Group III nitride stack 115 may include the following semiconductor layers.
Electron blocking layer 134: Undoped or Mg-doped AlN having a thickness of 5 nm.
P-type semiconductor layer 136: Mg-doped compositionally graded AlGaN (Al composition gradient ranging from 0.9 to 0.3) having a thickness of 12 nm.
P-type contact layer 138: Mg-doped GaN.
The p-type contact layer 138 may further include, for example, the following layers:
   First p-type contact layer 138a: Mg-doped GaN having a thickness of 120 nm.
   Second p-type contact layer 138b: Highly Mg-doped GaN having a thickness of 30 nm.
   The p-side electrode 146 is electrically connected to the p-type contact layer 138 through an opening 144a.
   The term "undoped" herein refers to the absence of intentional dopant introduction and does not necessarily indicate a dopant concentration of zero.

The lower Group III nitride stack 113 is provided between the base member 112 and the active layer 114, and may include one or more Group III nitride semiconductor layers (e.g., AlN, AlGaN, or InAlGaN) containing at least aluminum as a Group III constituent element.

The lower Group III nitride stack 113 may include a first nitride semiconductor layer 122 (Al_{w}Ga_{1-w}N layer), a second nitride semiconductor layer 132 (Al_{V}Ga_{1-V}N layer), and a third nitride semiconductor layer 130 (Al_{U}Ga_{1-U}N layer).

An exemplary lower Group III nitride stack 113 may include the following semiconductor layers:
First nitride semiconductor layer 122: Al_{W}Ga_{1-W}N (Al composition W, where 0 < W < 1, and Y < W ≤ V).
Second nitride semiconductor layer 132: Al_{V}Ga_{1-V}N (Al composition V, where V < 1, and W ≤ V < U).
Third nitride semiconductor layer 130: Al_{U}Ga_{1-U}N (Al composition U, where 0 < U ≤ X).

Specifically, at least a portion of the first nitride semiconductor layer 122 may exhibit n-type conductivity. The first nitride semiconductor layer 122 may include one or more Group III nitride semiconductor layers such as n-type AlGaN. An n-type dopant may be introduced into at least a part of the first nitride semiconductor layer 122, and this layer may be, for example, Si-doped A_{10.86}Ga_{0.14}N. The thickness of the first nitride semiconductor layer 122 may be in the range of 600 nm to 1200 nm. The second nitride semiconductor layer 132 may be formed of, for example, undoped AlGaN having a compositional gradient, which may be either continuous or stepwise. The thickness of the second nitride semiconductor layer 132 may be, for example, about 100 nm. The third nitride semiconductor layer 130 may be formed of, for example, undoped AlN. The thickness of the third nitride semiconductor layer 130 may be, for example, 200 nm.

The electron blocking layer 134 includes a heterobarrier layer that provides a barrier against electrons, and may further include a p-side spacer layer disposed between the heterobarrier layer and the active layer 114. The first nitride semiconductor layer 122 includes an n-type carrier supply layer that supplies electrons to the active layer 114, and may further include an n-side spacer layer disposed between the n-type carrier supply layer and the active layer 114.

The electron blocking layer 134 and the first nitride semiconductor layer 122 form a heterojunction with the active layer 114, thereby defining a potential well WELL in the active layer 114. Within this potential well WELL, an Al_{Y}Ga_{1-Y}N layer may be provided as either a single quantum well structure or the bulk light-emitting layer, the structure being defined by the arrangement of the first nitride semiconductor layer 122, the Al_{Y}Ga_{1-Y}N layer of the active layer 114, and the electron blocking layer 134. Alternatively, within this potential well WELL, the stacked structure 124a including multiple Group III nitride layers having different Al compositions may be provided. In any of these cases, the active layer 114 has an upper limit for its Al composition, for example, less than (Y + 0.04).

Providing the active layer 114 on an n-type Group III nitride semiconductor region having a low degree of lattice relaxation and being in contact with the primary surface of the base member 112 (specifically, the primary surface 120s of the template layer 120) may impose compressive strain on the active layer 114. In particular, such compressive strain is applied to the bulk light-emitting layer, the well layer 114b, and the barrier layer 114c.

In the light-emitting device 110, the lower Group III nitride stack 113 is disposed between the active layer 114 and the base member 112, and the upper Group III nitride stack 115 is disposed on the active layer 114. In this embodiment, the lower Group III nitride stack 113 forms a bond 119a with the base member 112, specifically with the template layer 120 of the template member 112c shown in FIG. 1, and may contain compressive strain due to Al_{X}Ga_{1-X}N. The lower Group III nitride stack 113 also forms a junction 119b with the active layer 114. The active layer 114 is bonded to the Al_{X}Ga_{1-X}N of the template layer 120 of the template member 112c. The upper Group III nitride stack 115 may also contain compressive strain due to Al_{X}Ga_{1-X}N. In contrast, at least a portion of the upper Group III nitride stack 115 may be lattice-relaxed. The upper Group III nitride stack 115 is provided on the active layer 114 and supplies carriers to the active layer 114.

Specifically, the lower Group III nitride stack 113 includes an underlayer, specifically a third nitride semiconductor layer 130 (Al_{U}Ga_{1-U}N layer, where U is equal to or less than X and greater than Y). The third nitride semiconductor layer 130 may be, for example, undoped, and may be provided so as to cover the primary surface of the template layer 120 or the single-crystal support 112b. In particular, the third nitride semiconductor layer 130 may be formed of AlN.

An exemplary third nitride semiconductor layer 130 may have a thickness of, for example, 4 µm. The third nitride semiconductor layer 130 may have a screw dislocation density of, for example, 9×108 cm-2. The third nitride semiconductor layer 130 (undoped Al_{U}Ga_{1-U}N layer) may contain compressive strain. The degree of lattice relaxation of the third nitride semiconductor layer 130 relative to the template layer 120 may be 2% or less. The third nitride semiconductor layer 130 may inherit the dislocation density and compressive strain of the template layer 120.

The lower Group III nitride stack 113 is formed on another underlayer, specifically a second nitride semiconductor layer 132 (Al_{V}Ga_{1-V}N layer). The second nitride semiconductor layer 132 may be, for example, undoped and may be formed of ternary AlGaN. The second nitride semiconductor layer 132 may be provided on the third nitride semiconductor layer 130 (Al_{U}Ga_{1-U}N layer). The second nitride semiconductor layer 132 may have a thickness of, for example, 4 µm, and may have a dislocation density of approximately 1×10⁶ cm⁻², including a screw component. The second nitride semiconductor layer 132 may also contain compressive strain derived from the underlying layer. In the case where the template layer 120 is formed of AlN, the third nitride semiconductor layer 130 may have a degree of lattice relaxation relative to the template layer 120 of 2% or less. In the light-emitting device 110, the second nitride semiconductor layer 132 may have an Al composition that decreases toward the active layer 114 while inheriting the threading dislocation density and compressive strain of the template layer 120. Specifically, the second nitride semiconductor layer 132 (Al_{V}Ga_{1-V}N layer) may have an Al composition gradient, for example, with V ranging from 1 to 0.86.

In the lower Group III nitride stack 113, the first nitride semiconductor layer 122 may have a degree of lattice relaxation relative to the template layer 120 of 2% or less. The n-type region of the first nitride semiconductor layer 122 is electrically connected to an electrode (n-side electrode 148). In this configuration, current flows through the first nitride semiconductor layer 122 both in the in-plane direction and along the axis Ax1. Increasing the thickness of the n-type semiconductor region can reduce its resistance, thereby lowering the drive voltage. However, if the n-type semiconductor region becomes excessively thick, its degree of lattice relaxation increases, which may hinder effective transmission of compressive strain to the active layer 114. A degree of lattice relaxation of 2% or less in the first nitride semiconductor layer 122 enables the n-type semiconductor region to have a sufficient thickness to provide a favorable current path while still effectively transmitting compressive strain to the active layer 114.

In this embodiment, the first nitride semiconductor layer 122 forms a junction 119c with the second nitride semiconductor layer 132 (Al_{V}Ga_{1-V}N layer). The second nitride semiconductor layer 132 forms a junction 119c with the third nitride semiconductor layer 130 (Al_{U}Ga_{1-U}N layer) and a junction 119d with the first nitride semiconductor layer 122 (AlGaN layer). The lower Group III nitride stack 113 includes the third nitride semiconductor layer 130 and the second nitride semiconductor layer 132 in addition to the first nitride semiconductor layer 122. The third nitride semiconductor layer 130 and the second nitride semiconductor layer 132 may constitute an underlayer that transmits the compressive strain of the template layer 120 to the active layer 114. The first nitride semiconductor layer 122 has an Al composition smaller than that of the second nitride semiconductor layer 132 and greater than the Al composition Y of the well layer 114b and the Al composition Z of the barrier layer 114c.

Referring to FIGS. 1 and 2, the light-emitting device 110 includes a protruding region 142. The protruding region 142 may include the upper Group III nitride stack 115, the active layer 114, and an upper portion of the lower Group III nitride stack 113 (specifically, an upper portion of the first nitride semiconductor layer 122).

The light-emitting device 110 may further include a passivation film 144 that covers the protruding region 142 and the first nitride semiconductor layer 122. The passivation film 144 has a first opening 144a on the upper surface of the protruding region 142 and a second opening 144b on the upper surface of the first nitride semiconductor layer 122 (specifically, on the n-type semiconductor surface of the first nitride semiconductor layer 122). The passivation film 144 may be formed of, for example, a silicon-based inorganic insulator such as silicon oxide, silicon nitride, or silicon oxynitride.

The light-emitting device 110 may include a p-side electrode 146 and an n-side electrode 148. The p-side electrode 146 is disposed in the first opening 144a and makes electrical contact with the upper surface of the p-type contact layer 138. The n-side electrode 148 is disposed in the second opening 144b and makes electrical contact with the n-type semiconductor surface of the first nitride semiconductor layer 122.

The electrodes may be formed of the following materials:
P-side electrode 146: Ni/Au (Au deposited on Ni)
N-side electrode 148: Ti/Al/Ni/Au

The base member 112, the upper Group III nitride stack 115, the active layer 114, and the lower Group III nitride stack 113 together form a nitride semiconductor structure 153. As shown in FIG. 1, in the nitride semiconductor structure 153, the base member 112 includes a first region 120a and a second region 120b, which are arranged along a reference plane Ref intersecting an axis Ax1 extending from the base member 112 toward the active layer 114. The n-side electrode 148 is located on the first region 120a, specifically on the lower Group III nitride stack 113, whereas the protruding region 142 and the p-side electrode 146 are located on the second region 120b, specifically on the upper surface of the upper Group III nitride stack 115. The p-side electrode 146 may have, for example, a comb shape. The n-side electrode 148 may include both a comb-shaped portion and a peripheral portion. The peripheral portion is provided along the base of the protruding region 142 so as to surround and enclose the protruding region 142.

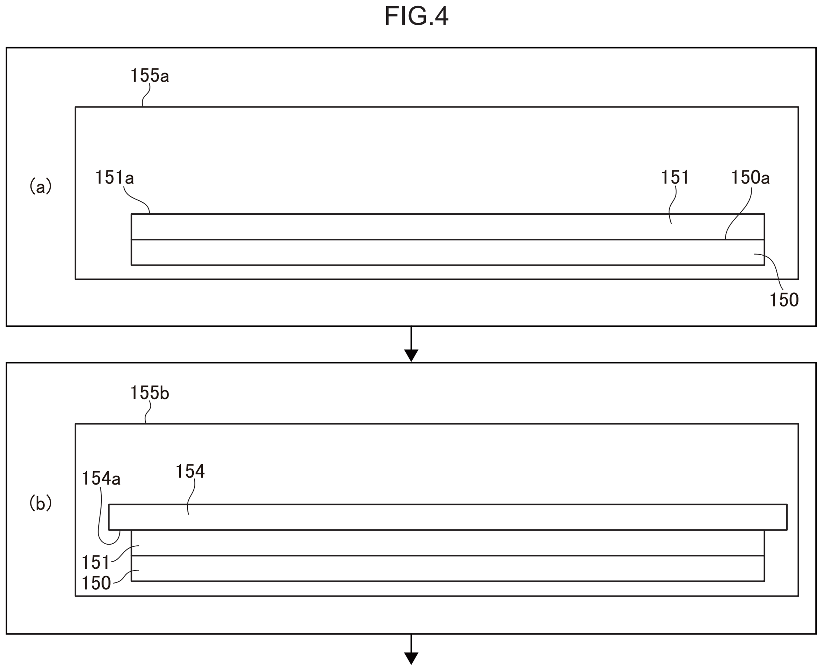

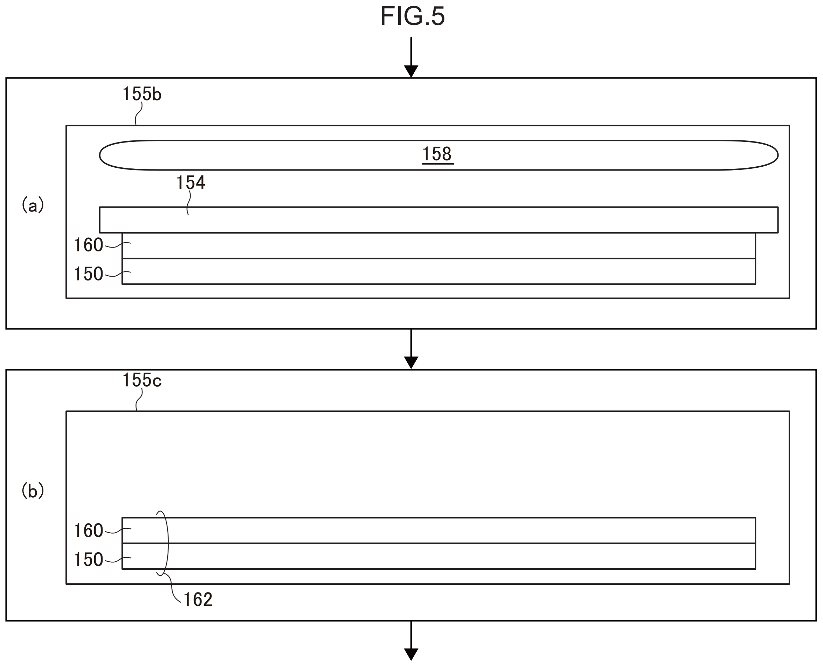

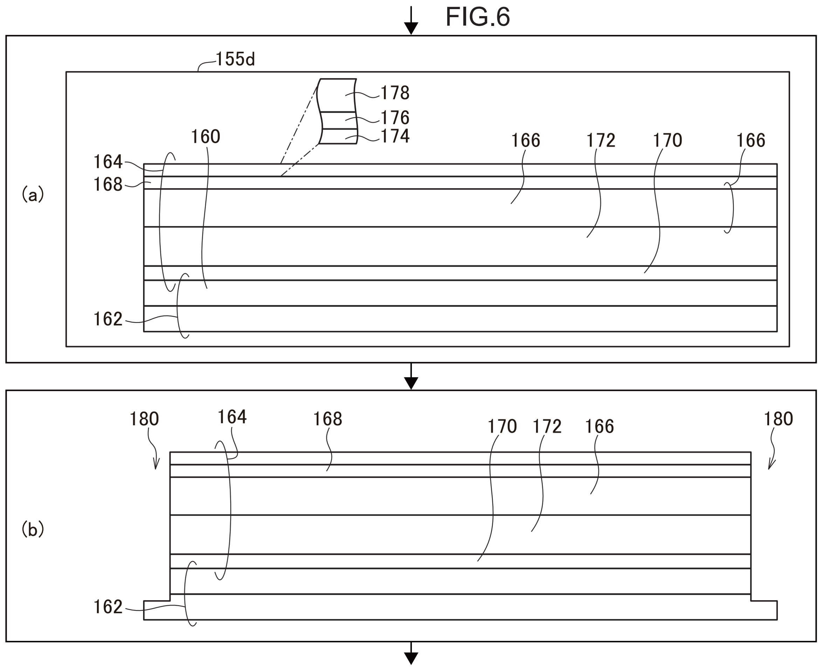

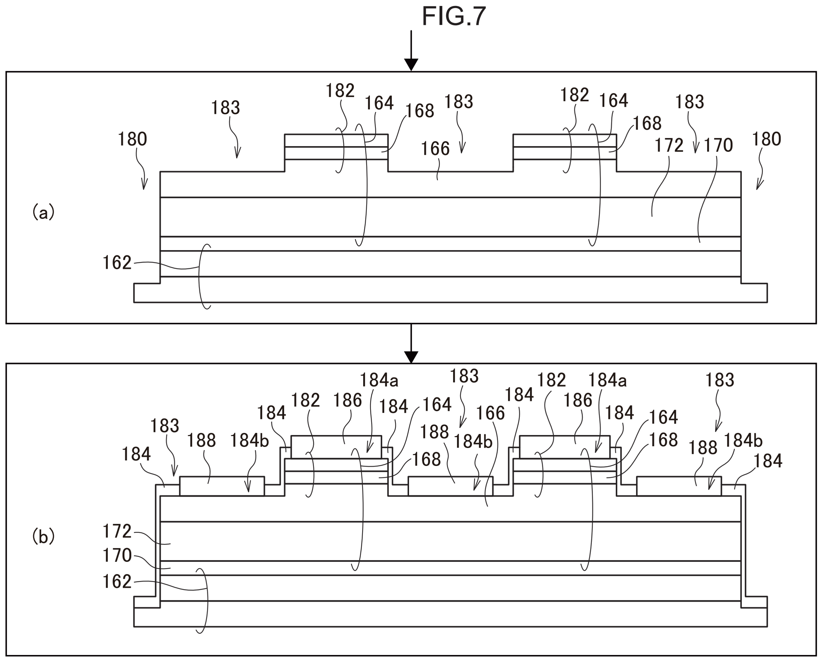

Parts (a) and (b) of FIG. 4, parts (a) and (b) of FIG. 5, parts (a) and (b) of FIG. 6, and parts (a) and (b) of FIG. 7 are diagrams illustrating the major steps of a method for fabricating the light-emitting device according to the present embodiment. In the following description of the fabrication method, a light-emitting diode (LED) structure is fabricated as an example of the light-emitting device.

As shown in part (a) of FIG. 4 through part (b) of FIG. 5, a template 162 is prepared. Preparing the template 162 may include fabricating the template 162 or alternatively obtaining it by another method.

Fabricating the template 162 may include the following steps:
In the step shown in part (a) of FIG. 4, a substrate 150 is prepared. The substrate 150 may be, for example, a 2-inch sapphire substrate. The substrate 150 is placed in a film-forming apparatus, and a precursor 151 for Al_{X}Ga_{1-X}N is deposited on the main surface 150a of the substrate 150. This deposition may be performed by sputtering, for example, using a sputtering apparatus 155a. The precursor 151 serves as a layer for forming an AlN template layer and is composed of a collection of Group III nitride crystal grains. The sputtering target may include AlN or AlGaN. Sputtering is performed at a pressure of approximately 0.05 Pa, thereby depositing the precursor 151 of AlN or AlGaN for the AlN template layer on the substrate 150. During deposition, the surface temperature of the substrate 150 is maintained within a range of 500 °C to 700 °C, for example, around 700 °C. For example, nitrogen gas may be used as the inert gas, and the flow rate of the nitrogen gas may be 10 sccm to 100 sccm (standard cubic centimeters per minute).

In the step shown in part (b) of FIG. 4, after deposition of the precursor 151, the intermediate product including the substrate 150 and the precursor 151 is placed in a heat-treatment apparatus 155b. In the heat-treatment apparatus 155b, a covering member 154 is disposed to face the precursor 151. At this time, the covering member 154 and the precursor 151 are positioned such that the maximum distance between the major surface 152a of the precursor 151 and the major surface 154a of the covering member 154 is preferably 0.5 mm or less. Alternatively, the covering member 154 may be another intermediate product that includes a substrate 150 and a precursor 151.

In the step shown in part (a) of FIG. 5, the substrate 150 and the precursor 151 are heat-treated using a heat-treatment apparatus 155b. In the heat-treatment apparatus 155b, an atmosphere 158 of a mixed gas containing an inert gas and ammonia (NH₃) is formed. In this atmosphere 158, the substrate 150 and the precursor 151 are heated to an annealing temperature. The annealing temperature may be, for example, 1600 °C or higher and 1750 °C or lower, such as approximately 1725 °C. The duration for which the substrate 150 and the precursor 151 are maintained at a temperature of 1400°C or higher may range from 20 minutes to 168 hours, and more preferably from 3 to 48 hours. In the heat-treatment apparatus 155b, the substrate 150 and the precursor 151 are maintained within the above temperature range and subjected to heat treatment for, for example, 20 minutes or longer. This heat treatment is referred to as face-to-face annealing (FFA). As a result of this heat treatment, a template 162 including a template layer 160 may be obtained. The template layer 160 is formed of Al_{X}Ga_{1-X}N (where X is greater than 0 and equal to or less than 1) and covers the major surface 150a of the substrate 150. The thickness of the template layer 160 may range, for example, from 100 nm to 2000 nm, and in this example, the thickness is 500 nm.

The covering member 154 may have a major surface 154a that is equal to or larger than the major surface 151a of the precursor 151. The major surface 154a of the covering member 154 may be made of carbon, boron nitride (BN), aluminum oxide (sapphire), a ceramic material, silicon carbide, a refractory metal, zirconia, tantalum carbide (TaC), or ScAlMgO4. The inert gas in the atmosphere 158 may include at least one of helium (He), nitrogen (N2), and argon (Ar).

In the step shown in part (b) of FIG. 5, the half-width of the (10-12) X-ray rocking curve is measured using an X-ray diffraction apparatus 155c. The template layer 160 has a half-width of the (10-12) X-ray rocking curve of 1000 arcsec or less. Through these processes, a template 162 may be formed on the substrate 150.

According to one example of a process for preparing the template 162, the template layer 160 may have an X-ray rocking curve of the (10-12) plane with a half-width of 1000 arcsec or less, and an X-ray rocking curve of the (0002) plane with a half-width of 100 arcsec or less.

The template layer 160 may be formed by sputter deposition followed by high-temperature heat treatment.

The prepared template 162 includes a substrate 150 and a template layer 160. The substrate 150 has a major surface 150a made of a material other than a Group III nitride. The template layer 160 is formed of Al_{X}Ga_{1-X}N (where X is greater than 0 and equal to or less than 1) and has an X-ray rocking curve half-width of the (10-12) plane of 1000 arcsec or less. The template layer 160 covers the major surface 150a of the substrate 150.

Specifically, the Al_{X}Ga_{1-X}N of the template layer 160 may be AlN and/or AlGaN. The template layer 160 may have a dislocation density of less than 5×10⁷ cm⁻² and may have a threading dislocation density of less than 9×10⁸ cm⁻².

The substrate 150 may be made of carbon, boron nitride (BN), aluminum oxide (sapphire), a ceramic material, silicon carbide, a refractory metal, zirconia, tantalum carbide (TaC), or ScAlMgO₄. For example, a sapphire substrate may typically have a size of 2 inches.

Specifically, the template layer 160 may have a hexagonal crystal structure. The major surface of the template layer 160 may have an off-angle greater than 0 degrees and equal to or less than 0.5 degrees relative to the c-plane of the crystal structure. The off-angle direction may be, for example, the [1-100] direction (m-axis direction) of the hexagonal crystal structure. This fabrication method provides exemplary ranges and directions for the off-angle.

Through the above steps, a template 162 including the template layer 160 is prepared. The Al_{X}Ga_{1-X}N of the template layer 160 may comprise AlN. A group III nitride stack 164 is then formed on the Al_{X}Ga_{1-X}N major surface of the template layer 160 or on a wafer of a bulk group III nitride single crystal. The major surface of the bulk group III nitride single-crystal wafer may have an off-angle greater than 0 degrees and equal to or less than 0.5 degrees relative to the c-plane of the crystal structure. The off-angle direction may be, for example, the [1-100] direction (m-axis direction) of the hexagonal crystal structure. This fabrication method provides exemplary ranges and directions for the off-angle. An exemplary group III nitride single-crystal substrate may be an AlN single-crystal wafer.

In the following description, the group III nitride stack 164 is grown on the template layer 160.

In the step illustrated in part (a) of FIG. 6, a group III nitride stack 164 is grown on the template layer 160. This growth may be performed by, for example, metalorganic vapor phase epitaxy (MOVPE) or molecular beam epitaxy (MBE). In the present embodiment, an MOVPE reactor 155d is used, and trimethylgallium (TMGa) and trimethylaluminum (TMAl) are employed as the gallium and aluminum precursors, respectively. Ammonia (NH3) is used as the nitrogen source.

The group III nitride stack 164 includes semiconductor films constituting the lower group III nitride stack 113 and the active layer 114. Specifically, the group III nitride stack 164 includes a nitride semiconductor region 166 and an active layer 168.

After the formation of the template layer 160, the nitride semiconductor region 166 is grown on the template layer 160. The nitride semiconductor region 166 may include one or more group III nitride semiconductor films.

This fabrication method may provide an Al_{X}Ga_{1-X}N film having an X-ray rocking curve half-width of 1000 arcsec or less in the (10-12) plane. On the Al_{X}Ga_{1-X}N template layer 160, an n-type group III nitride semiconductor film for the nitride semiconductor region 166 is then grown.

In this example, the n-type group III nitride semiconductor film is grown using silane (SiH₄) as an n-type dopant source. The nitride semiconductor region 166 may comprise an AlGaN layer having an Al composition of 0.80 or more. In this fabrication method, the nitride semiconductor region 166 may include an n-type dopant such as silicon. The partial pressure of ammonia (NH₃) may be 10 kPa or higher.

After the growth of the nitride semiconductor region 166, an active layer 168 is grown. Specifically, the active layer 168 may include AlGaN. By way of example and not limitation, the active layer 168 may be configured to generate light having a peak wavelength in the deep ultraviolet region of 240 nm or less. The active layer 168 may also be configured to generate light in the deep ultraviolet region down to 206 nm. The active layer 168 may include a group III nitride semiconductor containing compressive strain.

As previously described, the active layer 168 may include a bulk light-emitting layer in a single well, a stacked structure of multiple films in a single well, or a multiple quantum well structure. The multiple quantum well structure of the active layer 168 includes multiple well layers and one or more barrier layers. Each well layer and each barrier layer may contain compressive strain. The band gap of the compressively strained AlGaN in the well layers is smaller than that of the compressively strained AlGaN in the barrier layers. The active layer 168 is formed such that its Al composition G (see FIG. 1) is less than (Y + 0.04). Accordingly, the active layer 168 does not include a barrier layer having an excessively high potential barrier or a well layer having an excessively deep potential well. As an example, the active layer 168 may include InAlGaN capable of generating light in the deep ultraviolet wavelength region.

According to this fabrication method, the Al_{X}Ga_{1-X}N template layer 160 imparts compressive strain to one or more semiconductor films of the active layer 168 through a nitride semiconductor region having a low lattice relaxation rate (the semiconductor region of the lower group III nitride stack 113).

In this embodiment, one or more group III nitride semiconductor layers are grown prior to the growth of the nitride semiconductor region 166 and the active layer 168. The group III nitride stack 164 includes, in addition to the nitride semiconductor region 166 and the active layer 168, an undoped Al_{U}Ga_{1-U}N layer 170 and an undoped Al_{V}Ga_{1-V}N layer 172.

Specifically, an Al_{U}Ga_{1-U}N layer 170 (where 0 < u ≤ x and u > y) may be grown to cover the template layer 160. The Al composition of the Al_{U}Ga_{1-U}N layer 170 is greater than that of the nitride semiconductor region 166.

The Al_{U}Ga_{1-U}N layer 170 may be, for example, undoped. The screw dislocation density of the Al_{U}Ga_{1-U}N layer 170 may be 4×10⁶ cm⁻², and the threading dislocation density may be 9×10⁸ cm⁻². The Al_{U}Ga_{1-U}N layer 170 may contain compressive strain, and its lattice relaxation rate may be 2% or less. The Al_{U}Ga_{1-U}N layer 170 allows the threading dislocation density and compressive strain of the template layer 160 to be inherited. The Al_{U}Ga_{1-U}N layer 170 may be formed of AlN.

Specifically, another Al_{V}Ga_{1-V}N layer 172 (where V is less than 1 and greater than Y, and V is less than U) may be grown on the Al_{U}Ga_{1-U}N layer 170. The Al_{V}Ga_{1-V}N layer 172 has an Al composition greater than that of the nitride semiconductor region 166. The exemplary Al_{V}Ga_{1-V}N layer 172 may comprise AlGaN having a constant Al composition and/or graded AlGaN having a continuous or stepwise compositional change.

The Al_{V}Ga_{1-V}N layer 172 may be, for example, undoped. The screw dislocation density of the Al_{V}Ga_{1-V}N layer 172 may be 4×10₆ cm₋₂. The Al_{V}Ga_{1-V}N layer 172 may contain compressive strain. The Al_{V}Ga_{1-V}N layer 172 may have its Al composition decreased toward the active layer 168 while inheriting the threading dislocation density of the template layer 160. When the template layer 160 is made of AlN, the undoped Al_{V}Ga_{1-V}N layer 172 may have a lattice relaxation rate of 2% or less.

In this embodiment, the multiple group III nitride semiconductor layers grown on the template layer 160 may be grown coherently with respect to the template layer 160. Here, "grown coherently" refers to a manner of epitaxial growth in which the lattice constant remains substantially constant.

Subsequently, a plurality of group III nitride semiconductor layers (174, 176, and 178) for the group III nitride stack 164 are grown on the active layer 168. Specifically, the group III nitride stack 164 may include an electron blocking layer 174, a p-type compositionally graded layer 176, and a p-type contact layer 178. The electron blocking layer 174, the p-type compositionally graded layer 176, and the p-type contact layer 178 are successively grown on the active layer 168 in this order.

The process illustrated in part (b) of FIG. 6 forms grooves 180, which define the outer edges of the light-emitting device elements, by photolithography and etching. The etching may be carried out from the top surface of the group III nitride stack 164 down to the substrate 150, thereby forming the grooves 180.

The process illustrated in part (a) of FIG. 7 forms a protruding region 182 by photolithography and etching. The etching is performed to form a groove 183 extending from the upper surface of the group III nitride stack 164 to the nitride semiconductor region 166, thereby separating the active layer 168. The etching does not reach the Al_{V}Ga_{1-V}N layer 172. The upper portion of the nitride semiconductor region 166 is removed to expose its surface so that an n-side electrode can be formed thereon, while the lower portion of the nitride semiconductor region 166 is left to provide a lateral current path.

The process illustrated in part (b) of FIG. 7 forms a passivation film 184, a p-side electrode 186, and an n-side electrode 188. The passivation film 184 has a first opening 184a located on the top surface of the protruding region 182 and a second opening 184b located at the bottom of the groove 183 defining the protruding region 182.

Next, one of the electrodes, for example, the p-side electrode 186, is formed in the first opening 184a, and the other electrode, for example, the n-side electrode 188, is formed in the second opening 184b.

These steps complete the fabrication of the light-emitting device.

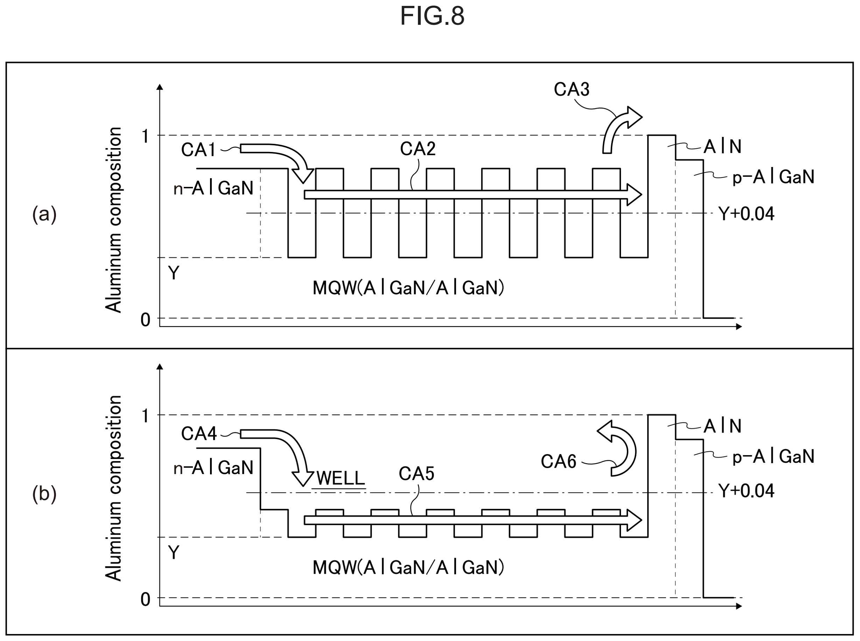

FIG. 8 illustrates the Al composition profile in the active layer and in the semiconductor regions adjacent thereto in the exemplary light-emitting device shown in FIGS. 1 and 3.

Referring to part (a) of FIG. 8, the active layer (MQW) of the exemplary light-emitting device has a multiple quantum well structure that forms a deep potential well, with an Al composition of (Y + 0.04) or more. Arrows CA1, CA2, and CA3 schematically illustrate the movement of carriers (electrons). As indicated by arrow CA1, electron current is injected from the n-type AlGaN layer (e.g., the first nitride semiconductor layer 122) into the first well layer. As indicated by arrow CA2, the electron current propagates within the active layer (MQW) while undergoing optical direct transitions. Upon reaching the end of the active layer (MQW), a portion of the remaining electron current leaks through the electron blocking layer (AlN) into the p-type semiconductor region, as indicated by arrow CA3, where the carriers recombine.

Referring to part (b) of FIG. 8, the active layer of another exemplary light-emitting device has a deep potential well (WELL). The active layer of this light-emitting device includes a shallow multiple quantum well (MQW) structure disposed within the deep potential well (WELL). Arrows CA4, CA5, and CA6 schematically illustrate the movement of carriers (electrons). Arrow CA4 indicates injection of electron flow from the first nitride semiconductor layer 122 into the first well layer. Arrow CA5 indicates propagation of the electron flow within the active layer (MQW) while undergoing optical direct transitions. Arrow CA6 indicates that, upon reaching the end of the active layer (MQW), the electron flow is repelled by the high barrier of the electron blocking layer (AlN). Accordingly, the electron flow is unlikely to leak into the p-type semiconductor region.

Setting an upper limit on the Al composition of the active layer 114 reduces the difference in Al composition (ΔWB) between the barrier layer 114c and the well layer 114b, thereby weakening quantum confinement. However, by setting such an upper limit, a deep potential well (WELL) is provided in the active layer 114. The first nitride semiconductor layer 122 and the electron blocking layer 134 can firmly confine carriers within the WELL (see part (b) of FIG. 8), which is formed by these layers. This potential well (WELL) fully utilizes the heterobarriers of the first nitride semiconductor layer 122 and the electron blocking layer 134, both composed of existing materials, for effective carrier confinement. The potential well (WELL) enables efficient carrier confinement and, together with the shallow potential stacked structure 124a and the shallow potential multiple quantum well structure 114a within the WELL, allows emission of light at the desired wavelength from the bulk light-emitting layer.

Specifically, the active layer 114 of the potential well (WELL) is made of an Al_{Y}Ga_{1-Y}N layer functioning as a bulk light-emitting layer. The Al_{Y}Ga_{1-Y}N layer is provided between the first nitride semiconductor layer 122 and the electron blocking layer 134, and is configured to generate light having a peak wavelength in the deep ultraviolet region of 240 nm or less and 206 nm or more. The depth of the potential well (WELL) is determined by the difference in Al composition between the maximum Al composition of the electron blocking layer 134 and the Al composition Y of the Al_{Y}Ga_{1-Y}N layer, which is set to 0.18 or more. Additionally, the potential well (WELL) may be defined by the difference between the maximum Al composition of the first nitride semiconductor layer 122 and the Al composition Y of the Al_{Y}Ga_{1-Y}N layer, which may be set to 0.06 or more.

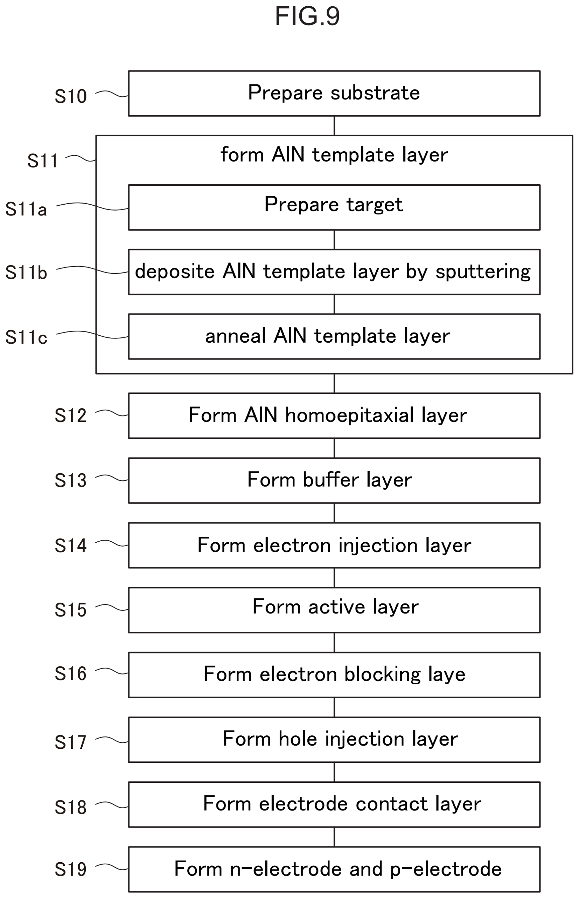

FIG. 9 is a flow chart illustrating the principal steps of a method for fabricating a nitride light-emitting device according to this embodiment.

The light-emitting diode includes a bulk AlN substrate or a sapphire template, an AlN homoepitaxial layer, an AlGaN layer, an n-type electron-spreading layer, an active layer, an electron blocking layer, a p-type hole injection layer, and a p-type contact layer. These semiconductor layers are stacked in this order. An n-side electrode is connected to the electron-spreading layer of the n-type AlGaN layer, and a p-side electrode is connected to the p-type contact layer.

A method for forming the template member according to this embodiment will now be described.

In step S10, a substrate is prepared. The substrate may be, for example, a sapphire substrate. However, the substrate is not limited to sapphire and may be formed of at least one material selected from the group consisting of carbon, boron nitride (BN), ceramic, silicon carbide, refractory metals, zirconia, tantalum carbide (TaC), and ScAlMgO₄.

In step S11, an AlN template layer is formed on the sapphire substrate. The AlN template layer consists essentially of AlN and is formed to enable the growth of an epitaxial layer having good crystallinity on the substrate. The primary surface of the AlN template layer substantially corresponds to a hexagonal c-plane. In this embodiment, the AlN template layer provides the following advantages: The lattice constant of AlN can be well matched with that of AlGaN used in the active layer of an ultraviolet light-emitting diode; AlN on a sapphire substrate exhibits high transmittance to ultraviolet light; and AlN has high thermal conductivity. These characteristics make AlN suitable as a template layer. AlGaN, in which a small number of Al atoms in AlN are replaced by Ga atoms, also exhibits similar properties.

In step S11a, a desired sputtering target is prepared. In step S11b, a precursor for the AlN template layer is deposited, for example, by sputtering. In step S11c, the deposited precursor is subjected to heat treatment. Specifically, the precursor for the AlN template layer may be formed by one or more depositions on the surface of a sapphire substrate using, for example, reactive sputtering, followed by one or more heat treatments applied to the deposited AlN and the sapphire substrate to form the template layer. The deposition and heat treatment steps may be alternately performed. The method for forming the template layer is not limited to reactive sputtering and may alternatively be carried out by metalorganic vapor phase epitaxy (MOVPE), molecular beam epitaxy (MBE), or hydride vapor phase epitaxy (HVPE).

Increasing the thickness of the template layer reduces the threading dislocation density in the AlN of the template layer. This reduction can improve the internal quantum efficiency of the active layer subsequently formed on the template layer. Conversely, decreasing the thickness of the template layer reduces the likelihood of cracks occurring in the template layer, thereby improving the yield of light-emitting diodes fabricated using the template layer. Specifically, the thickness of the AlN template layer may be in the range of 100 to 10,000 nm, and more preferably in the range of 500 to 1,500 nm. By performing sputtering deposition and heat treatment one or more times, this thickness range provides both a sufficiently low threading dislocation density and a sufficiently low occurrence of cracks in the template layer.

Next, a bulk single-crystal AlN substrate or a sapphire template is prepared. In the following description, an epitaxial structure for a light-emitting diode is formed on the AlN template layer of the sapphire substrate. This epitaxial structure may be formed by a deposition technique such as MOVPE, HVPE, or MBE. In this example, all layers formed on the AlN template layer are deposited by MOVPE.

In step S12, an AlN homoepitaxial layer is formed. Specifically, prior to forming the AlN homoepitaxial layer on the AlN template layer, the surface of the AlN template layer may, if necessary, be subjected to a surface treatment (surface cleaning) in the MOVPE reactor. This surface treatment may include a heat treatment performed for approximately 10 minutes in a high-temperature atmosphere. The surface treatment may be conducted in an atmosphere of H₂ and NH₃, or in a mixed atmosphere of H₂, NH₃, and N₂. The treatment temperature may be, for example, 1200 °C or higher, and more preferably 1300°C or higher. This treatment removes oxides and organic contaminants present on the surface of the AlN template layer and suppresses the introduction of defects into the subsequently grown layers, from the AlN homoepitaxial layer up to the contact layer. The treatment pressure may be, for example, 13 kPa.

### (AlN Homoepitaxial Layer)

The homoepitaxial layer is made of the same material as the surface of the template layer or the bulk AlN substrate. In this embodiment, the homoepitaxial layer is, for example, AIN. The homoepitaxial layer has a surface exhibiting superior flatness compared to that of the AlN template layer and functions as a barrier preventing residual impurities (e.g., carbon (C), oxygen (O), and silicon (Si)) contained in the template layer from diffusing into the layers grown above it. The thickness of the homoepitaxial layer may be, for example, in the range of 10 to 10,000 nm, and more preferably in the range of 50 to 1,000 nm. In one example, the thickness of the AlN homoepitaxial layer may be 200 nm. The AlN homoepitaxial layer may be grown using H₂ as a carrier gas and NH₃ and TMAl as source materials, under a growth pressure of 13 kPa and at a substrate temperature of 1300 °C.

In step S13, a buffer layer, such as an AlGaN buffer layer, is formed on the homoepitaxial layer. The buffer layer may be composed of a Group III nitride having the composition (Al_{y1}Ga_{z1}In_{1-y1-z1}N, where 0 < y1 ≤ 1, 0 ≤ z1 < 1, y1 + z1 ≤ 1). Specifically, the buffer layer functions to adjust the lattice constant between the layer formed beneath it and the layer formed thereon. The buffer layer may be made of, for example, AlGaN or AlGaInN. For instance, when an AlGaN layer (e.g., an active layer) is formed on an AlN layer (e.g., an AlN template layer or an AlN homoepitaxial layer), because the inherent lattice constants of AlN and AlGaN differ, a buffer layer is provided between them to mitigate the lattice mismatch. The buffer layer may have a structure in which the lattice constant varies continuously or discontinuously in the stacking direction. The buffer layer may be undoped, meaning that no dopant is intentionally introduced, and may contain an n-type dopant such as Si, Ge (germanium), Sn (tin), O (oxygen), S (sulfur), Se (selenium), or Te (tellurium) to impart n-type conductivity. An exemplary buffer layer is a compositionally graded AlGaN layer having a thickness of approximately 100 nm.

In step S14, an electron-spreading layer is formed on the buffer layer. Specifically, the electron-spreading layer may be composed of a Group III nitride having the composition (Al_{y2}Ga_{z2}In_{1-y2-z2}N, where 0 < y2 ≤ 1, 0 ≤ z2 < 1, y2 + z2 ≤ 1). The electron-spreading layer may be made of, for example, AlGaN or AlGaInN and may contain an n-type dopant to impart n-type conductivity. Accordingly, the electron-spreading layer serves as a conduction path through which electrons are supplied to and propagate toward the active layer.

Providing a high Al composition in the electron-spreading layer can reduce the lattice mismatch between AlN (e.g., an AlN template layer or an AlN homoepitaxial layer) and the Group III nitride (e.g., AlGaN) that constitutes the electron-spreading layer. This reduction in lattice mismatch can effectively suppress the formation of misfit dislocations caused by lattice relaxation. An electron-spreading layer having a high Al composition can also transfer compressive strain from the template layer to the active layer. As a result, the performance of the LED can be improved, particularly through enhancement of the internal quantum efficiency and narrowing of the emission spectrum.

The Al composition of the electron-spreading layer may be, for example, in the range of 0.8 to 0.9. This composition range can prevent the electron-spreading layer from exhibiting undesirably low conductivity that may occur when the Al composition is excessively high. The thickness of the electron-spreading layer may be, for example, in the range of 600 to 1200 nm, providing sufficient strain to the active layer. An exemplary electron-spreading layer is an n-type Al0.86Ga0.14N layer having a thickness of approximately 1200 nm.

Growth conditions for the AlGaN electron-spreading layer are as follows:
Growth pressure: 40 kPa.
Substrate temperature: 1050°C.

In step S15, an active layer is formed. Specifically, the active layer has a structure including alternating stacked AlGaN well layers and AlGaN barrier layers. The AlGaN well layers and the AlGaN barrier layers each contain AlGaN with respective Al compositions. In particular, the Al composition of the AlGaN well layers is lower than that of the AlGaN barrier layers. The number of AlGaN well layers may be, for example, seven. The uppermost layer of the active layer may be either an AlGaN well layer or an AlGaN barrier layer, and thus the active layer may be in contact with the electron-blocking layer. For example, the lowermost AlGaN well layer or barrier layer of the active layer may be in contact with the electron-spreading layer, and thus the active layer may be in contact with the first nitride semiconductor layer 122. Furthermore, the multiple AlGaN well layers may have the same or different thicknesses and Al compositions. At least some of the multiple AlGaN well layers may have thicknesses different from those of the remaining AlGaN well layers. The emission wavelength of the active layer may be in the range of 206 to 240 nm, and the Al composition of the bulk light-emitting layer may be in the range of 0.73 to 1. For example, an AlGaN well layer may have a thickness of 2 nm and an Al composition of 0.792, while an AlGaN barrier layer may have a thickness of 3 nm and an Al composition of 0.801.

Growth conditions for the AlGaN active layer are as follows:
Growth pressure: 40 kPa.
Substrate temperature: 1050 °C.

The AlGaN barrier layer may be in contact with the electron-spreading layer, or the AlGaN well layer may be in contact with the electron-spreading layer. Similarly, the AlGaN barrier layer may be in contact with the electron-blocking layer, or the AlGaN well layer may be in contact with the electron-blocking layer.

In step S16, an electron-blocking layer is formed on the active layer. Specifically, the electron-blocking layer is made of a nitride containing a Group III element as a constituent element (Al_{y3}Ga_{z3}In_{1-y3-z3N}, where 0 < y3 ≤ 1, 0 ≤ z3 < 1, y3 + z3 ≤ 1). The electron-blocking layer may be made of, for example, at least one of AlN, AlGaN, and AlGaInN, such as undoped AlN. The bandgap energy of the electron-blocking layer is greater than that of the AlGaN barrier layer. The electron-blocking layer prevents electrons supplied from the electron-spreading layer from leaking out of the active layer into the hole-injection layer.
The thickness of the electron-blocking layer may be in the range of 1 to 20 nm, and more preferably in the range of 3 to 10 nm. The electron-blocking layer may have a structure in which the bandgap energy changes continuously or stepwise in the stacking direction of the semiconductor film, i.e., a compositionally graded structure. The electron-blocking layer may be undoped, meaning that it is not intentionally doped with impurities, or it may be doped with a p-type dopant such as Mg (magnesium), Be (beryllium), C (carbon), or Zn (zinc) to impart p-type conductivity.

Growth conditions for the AlN electron-blocking layer are as follows:
Growth pressure: 40 kPa.
Substrate temperature: 1050 °C.

In step S17, a hole-injection layer, such as a p-type AlGaN layer, is formed. Specifically, the hole-injection layer may be made of at least one of AlN, AlGaN, and AlGaInN. The hole-injection layer is made of a nitride containing a Group III element as a constituent element (Al_{y4}Ga_{z4}In_{1-y4-z4}N, where 0 ≤ y4 ≤ 1, 0 ≤ z4 ≤ 1, and y4 + z4 ≤ 1). The hole-injection layer may have p-type conductivity imparted by the addition of a p-type dopant such as Mg (magnesium), Be (beryllium), C (carbon), or Zn (zinc). The hole-injection layer provides a conduction path for supplying holes to the active layer. The bandgap energy of the hole-injection layer is smaller than that of the electron-blocking layer and greater than that of the contact layer, which will be described below. The hole-injection layer may have a structure in which the bandgap energy changes continuously or stepwise in the direction from the active layer toward the electron-blocking layer, i.e., a compositionally graded structure, specifically a structure in which the bandgap energy decreases. The thickness of the hole-injection layer may be in the range of 1 to 50 nm.

In step S18, a contact layer is grown on the hole-injection layer. The contact layer is a nitride containing a Group III element as a constituent element (Al_{y5}Ga_{z5}In_{1-y5-z5}N, where 0 ≤ y5 ≤ 1, 0 ≤ z5 < 1, and y5 + z5 ≤ 1). The contact layer may be made of, for example, at least one of GaN, InGaN, AlGaN, and AlGaInN. The contact layer may have p-type conductivity imparted by the addition of a p-type dopant.

The contact layer may include a plurality of GaN layers having different dopant concentrations. In this embodiment, the contact layer may include a first contact layer and a second contact layer. The first contact layer may have a dopant concentration in the range of 5×10¹⁷ to 5×10¹⁹ cm⁻³. The second contact layer may be GaN having an Mg dopant concentration in the range of 5×10¹⁹ to 1×10²¹ cm⁻³, thereby reducing the contact resistance between the semiconductor and the metal electrode.

In step S19, an n-side electrode and a p-side electrode are formed. Specifically, the n-side electrode is in contact with the surface of the electron-spreading layer. The n-side electrode may contain at least one metal selected from the group consisting of Al (aluminum), Ti (titanium), Ni (nickel), V (vanadium), Zr (zirconium), Mo (molybdenum), Ru (ruthenium), Rh (rhodium), Pd (palladium), Ag (silver), In (indium), Sn (tin), Ta (tantalum), W (tungsten), Pt (platinum), and Au (gold). The n-side electrode may be formed of an alloy including one or more of these metals. The n-side electrode may further contain a conductive oxide or a conductive nitride.

The p-side electrode is in contact with the surface of the contact layer. The p-side electrode may contain at least one metal selected from the group consisting of Al (aluminum), Ti (titanium), Ni (nickel), V (vanadium), Zr (zirconium), Mo (molybdenum), Ru (ruthenium), Rh (rhodium), Pd (palladium), Ag (silver), In, Sn (tin), Ta (tantalum), W (tungsten), Pt (platinum), and Au (gold). The p-side electrode may be formed of an alloy including one or more of these metals. The p-side electrode may further contain a conductive oxide or a conductive nitride.

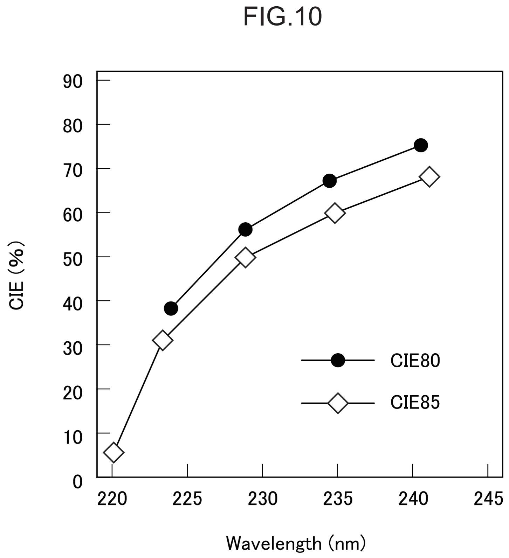

FIG. 10 shows simulation results illustrating the relationship between current injection efficiency (CIE) and emission wavelength.
Simulator: SiLENSe ver. 6.4
Al composition of electron-blocking layer: 1.0
Well layer thickness: 2 nm
Barrier layer thickness: 3 nm
Characteristic line CIE80: Al composition of well layer, 0.6-0.8; Al composition of barrier layer, 0.80
Characteristic line CIE85: Al composition of well layer, 0.6-0.8; Al composition of barrier layer, 0.85

In light emission with a wavelength of 240 nm or less, the current injection efficiency decreases as the emission wavelength becomes shorter. Reducing the Al composition of the barrier layer to shift the energy level associated with optical transitions away from the heterobarrier of the electron blocking layer improves the injection efficiency.

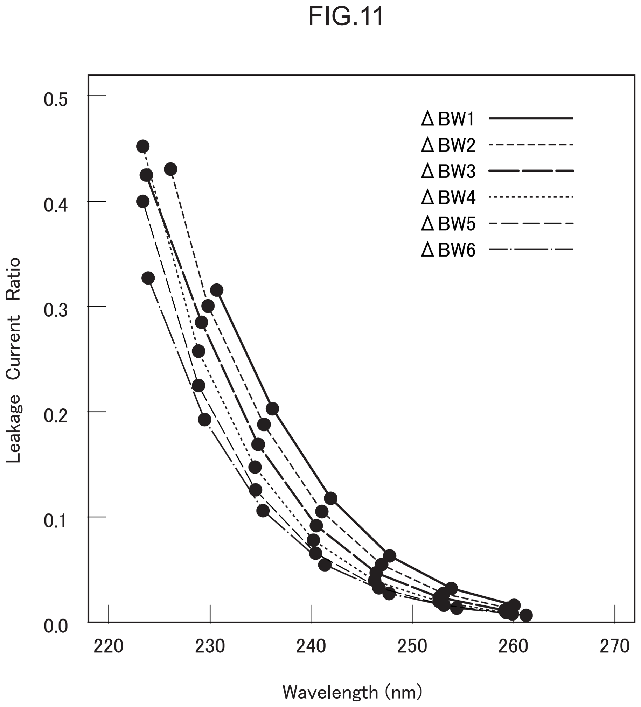

FIG. 11 is a diagram showing simulation results illustrating the relationship between leakage current and emission wavelength. The horizontal axis represents the emission wavelength, and the vertical axis represents the leakage current ratio. The leakage current ratio is defined as the ratio (NH/NE) of the number of holes (NH) reaching the n-side electrode to the number of electrons (NE) reaching the p-side electrode under the current applied to the light-emitting diode. The leakage current is mainly composed of electron flow; therefore, suppressing electron leakage is important. Attention should also be paid to the heterobarrier on the n-side in relation to hole leakage.

Characteristic lines ΔBW1, ΔBW2, ΔBW3, ΔBW4, ΔBW5, and ΔBW6 represent the differences in Al composition between the barrier layer and the well layer, as follows.

Characteristic line ΔBW1: 0.30
Characteristic line ΔBW2: 0.25
Characteristic line ΔBW3: 0.20
Characteristic line ΔBW4: 0.15
Characteristic line ΔBW5: 0.10
Characteristic line ΔBW6: 0.05

The difference in Al composition between the barrier layer and the well layer may be less than 0.07. The difference in Al composition may also be less than 0.06. Further, the difference in Al composition may be less than 0.05.

The results shown in FIG. 11 indicate that the leakage current increases significantly when the emission wavelength is shorter than 250 nm. The increase in leakage current is particularly pronounced in the wavelength region of 240 nm or less. Furthermore, when the Al composition of the electron-blocking layer is fixed, reducing the difference in Al composition between the barrier layer and the well layer decreases the leakage current. Accordingly, when the difference in Al composition between the barrier layer and the well layer is 0.04 or less, the leakage current can be further reduced.

At a given emission wavelength, reducing the difference in Al composition between the barrier layer and the well layer weakens quantum confinement while lowering the leakage current ratio. A reduction in the leakage current ratio leads to an improvement in external quantum efficiency. Experimental results exhibit behavior consistent with the simulation results. Furthermore, reducing the difference in Al composition between the barrier layer and the well layer allows the energy level associated with optical transitions to be separated from the heterobarrier energy level of the electron-blocking layer. In addition, separating the energy level associated with optical transitions from the maximum value of the heterobarrier can further improve external quantum efficiency. These advantages also apply to the energy level associated with optical transitions in the bulk light-emitting layer.

As described above, according to this embodiment, it is possible to provide a Group III nitride light-emitting device that suppresses a decrease in external quantum efficiency caused by a reduction in the band offset between the active layer and the electron-blocking layer.

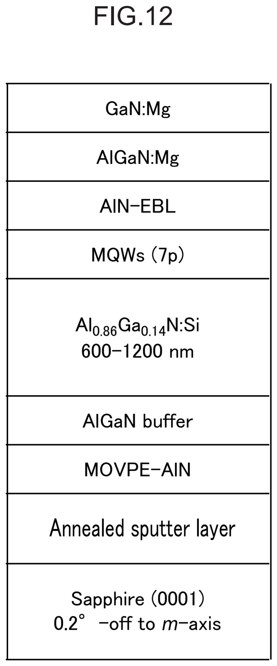

FIG. 12 illustrates an exemplary structure of a light-emitting diode (LED). In FIG. 12, the anode and cathode electrodes connected to the p-type and n-type semiconductor regions are not shown.

An exemplary structure of the light-emitting diode (LED) is as follows:
N-type semiconductor layer: Al_{0.86}Ga_{0.14}N layer, thickness 600-1200 nm
Multiple quantum well (MQW) structure: 7 well layers
Well layer: AlGaN, thickness 2 nm, Al composition 0.792
Barrier layer: AlGaN, thickness 3 nm, Al compositions 0.823 and 0.801

Next, an evaluation of the crystalline quality of the LED structure is described.

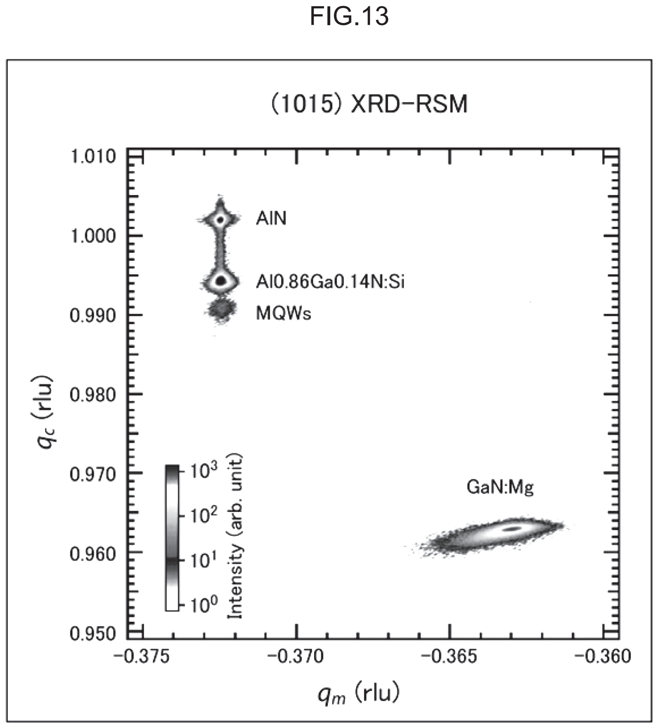

FIG. 13 shows an X-ray diffraction reciprocal space mapping (XRD-RSM) image of the (10-15) plane obtained by X-ray diffraction (XRD) of the LED structure shown in FIG. 12. The symbol "-1" in the plane index indicates that a bar is drawn over the numeral "1" in the figure.

The n-type semiconductor layer (Al_{0.86}Ga_{0.14}N) is lattice-relaxed, while the p-type GaN contact layer and the multiple quantum well (MQW) structure are coherently grown on the AlN template layer.

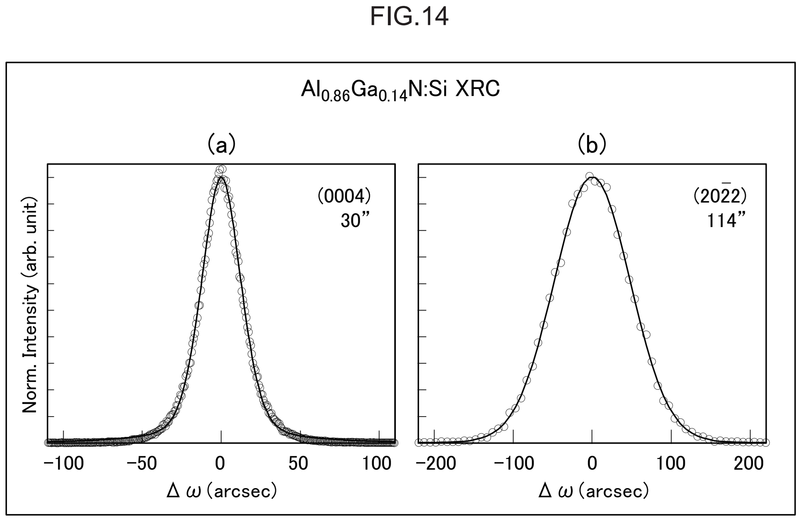

FIG. 14 shows X-ray diffraction (XRD) images of the n-type semiconductor layer (Al_{0.86}Ga_{0.14}N). Diffraction peak images of the (0004) and (20-22) planes are shown. The symbol "-2" in the plane index indicates that a bar is drawn over the numeral "2" in the figure. Full width at half maximum (FWHM) of the diffraction image of the (0004) plane: 30 arcsec Full width at half maximum (FWHM) of the diffraction image of the (20-22) plane: 114 arcsec

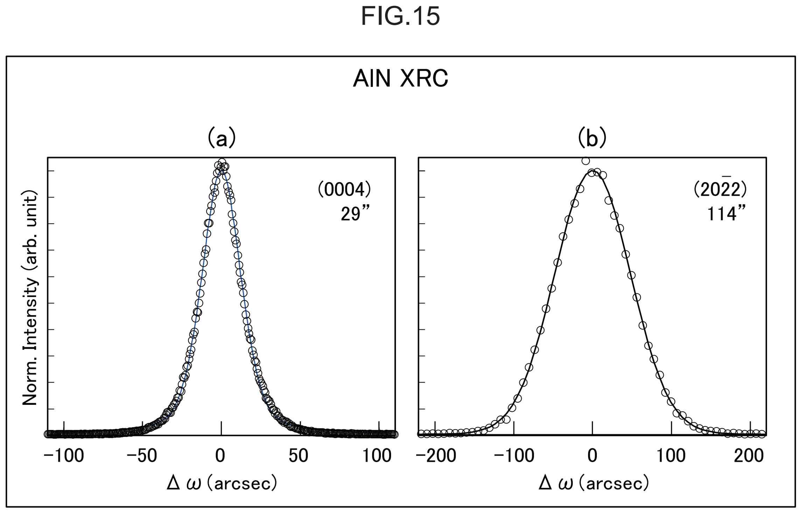

Parts (a) and (b) of FIG. 15 show diffraction peak images of the (0004) and (20-22) planes of an AlN single crystal on a sapphire support.
FWHM of the diffraction image of the (0004) plane: 29 arcsec
FWHM of the diffraction image of the (20-22) plane: 114 arcsec

The dislocation densities of the n-type semiconductor layer and the AlN single crystal, estimated from the measurements of parts (a) and (b) of FIG. 14 and parts (a) and (b) of FIG. 15, are as follows:
Screw/mixed dislocation density: less than 1×10⁵ cm⁻²
Edge dislocation density: less than 1×10⁸ cm⁻²

Next, the evaluation of the electrical characteristics of the LED structure is described.

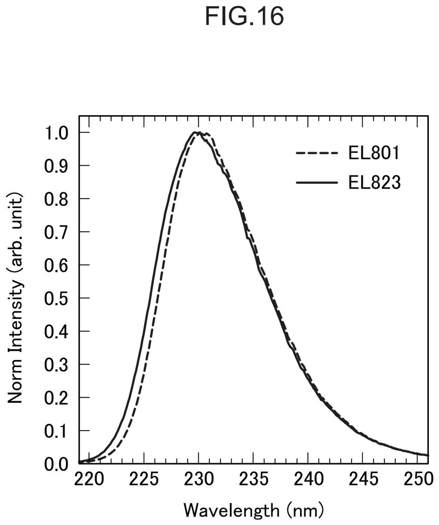

FIG. 16 is a diagram illustrating the electroluminescence (EL) characteristics of the LED structure. Referring to FIG. 16, characteristic lines EL823 and EL801 are shown.

The LED structure corresponding to characteristic line EL823 has the following multiple quantum well (MQW) structure:
Multiple quantum well (MQW) structure: 7 well layers
Well layer: AlGaN, thickness 2 nm, Al composition 0.792
Barrier layer: AlGaN, thickness 3 nm, Al composition 0.823
EL peak wavelength: 229.5 nm

The LED structure corresponding to characteristic line EL801 has the following multiple quantum well (MQW) structure:
Multiple quantum well (MQW) structure: 7 well layers
Well layer: AlGaN, thickness 2 nm, Al composition 0.792
Barrier layer: AlGaN, thickness 3 nm, Al composition 0.801
EL peak wavelength: 230.2 nm

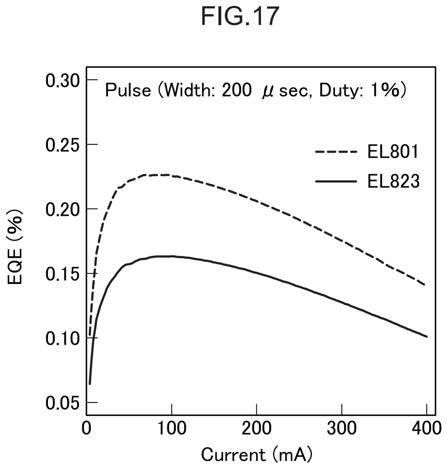

FIG. 17 is a diagram illustrating the external quantum efficiency (EQE) of the LED structure. Referring to FIG. 17, characteristic lines EQE823 and EQE801 are shown. Decreasing the Al composition of the barrier layer increases the external quantum efficiency of the LED structure.

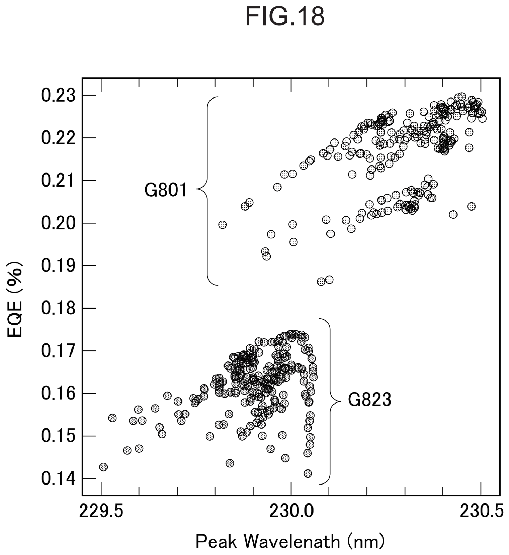

FIG. 18 is a diagram illustrating the relationship between the emission wavelength and the external quantum efficiency (EQE) of an LED structure. Referring to FIG. 18, groups G801 and G823 are shown. Group G801 includes on-wafer measurement values of an LED structure having a multiple quantum well (MQW) structure with barrier layers 3 nm thick and having an Al composition of 0.801. Group G823 includes on-wafer measurement values of an LED structure having a multiple quantum well (MQW) structure with barrier layers 3 nm thick and having an Al composition of 0.823.

When comparing the external quantum efficiency (EQE) of on-wafer LED structures with the same emission wavelength within the emission wavelength distributions of groups G801 and G823, the LED structure of group G801 exhibits higher external quantum efficiency than that of group G823.

The external quantum efficiency (EQE) of deep-ultraviolet LEDs decreases as the emission wavelength becomes shorter within the range of 240 nm to 206 nm.

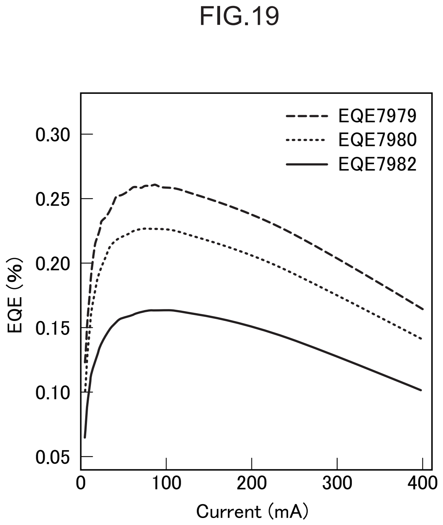

FIG. 19 illustrates the relationship between the injection current into the LED structure and the external quantum efficiency (EQE). FIG. 19 shows external quantum efficiency characteristics labeled EQE7982, EQE7980, and EQE7979.
EQE7982: Characteristics of a multiple quantum well (MQW) structure (ΔWB = 0.03) having well layers with an Al composition of 0.79 and barrier layers with an Al composition of 0.82.
EQE7980: Characteristics of an MQW structure (ΔWB = 0.01) having well layers with an Al composition of 0.79 and barrier layers with an Al composition of 0.80.
EQE7979: Characteristics of a bulk light-emitting layer in which both the well layers and the barrier layers are grown with the same Al composition of 0.79.
Reducing the average Al composition of the active layer increases the external quantum efficiency.

Subsequent characteristic evaluations are performed using assembled devices. The assembled devices (DEV_A and DEV_B) are prepared by flip-chip mounting the LED structure on an AlN ceramic package using AuSn solder.

DEV_A: Al composition of barrier layer: 0.797
Al composition of well layer: 0.785
Difference in Al composition between barrier layer and well layer: 0.012
Emission wavelength: 230 nm

DEV_B: Al composition of barrier layer: 0.743
Al composition of well layer: 0.730
Difference in Al composition between barrier layer and well layer: 0.013
Emission wavelength: 236 nm

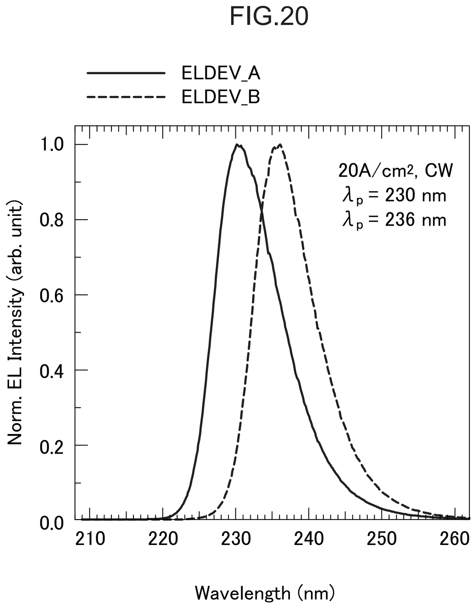

FIG. 20 illustrates the EL spectra of the assembled devices (DEV_A and DEV_B).
Full width at half maximum (FWHM) of assembled device DEV_A: 10 nm
Full width at half maximum (FWHM) of assembled device DEV_B: 10 nm

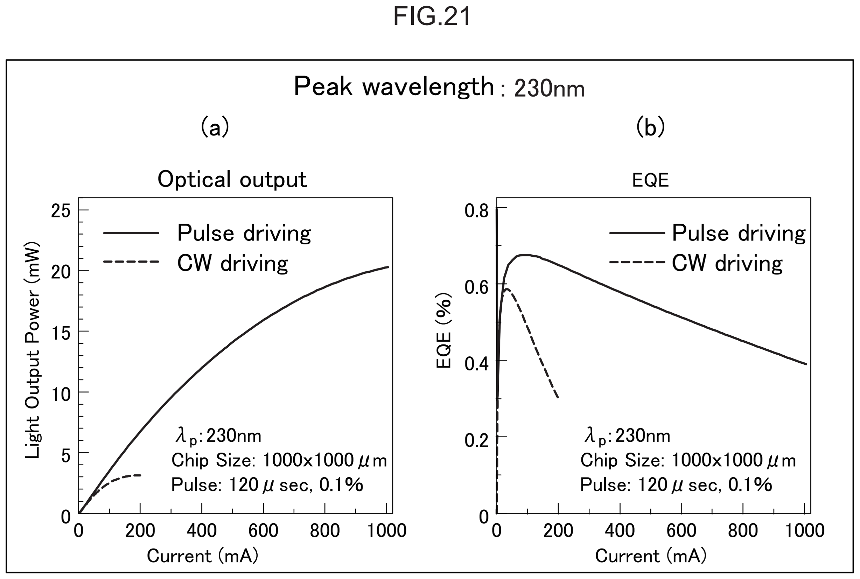

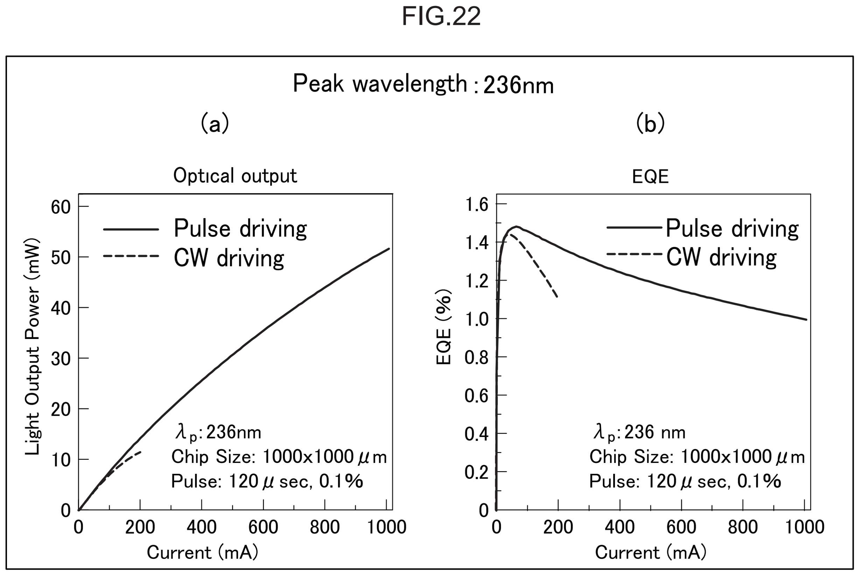

Parts (a) and (b) of FIG. 21 show the dependence of optical output and external quantum efficiency on injection current for the assembled device DEV_A (emission wavelength: 230 nm). Parts (a) and (b) of FIG. 22 show the dependence of optical output and external quantum efficiency on injection current for the assembled device DEV_B (emission wavelength: 236 nm). The optical output and external quantum efficiency of the assembled devices (DEV_A and DEV_B) were measured under both pulse driving and continuous wave (CW) driving conditions. The pulse width was 120 microseconds, and the duty ratio was 0.1%.

Under CW operation, the assembled device DEV_A exhibited an optical output of 3.12 mW and a maximum external quantum efficiency of 0.59% at a current of 191 mA. Under pulse operation, the assembled device DEV_A exhibited an optical output of 20.3 mW and a maximum external quantum efficiency of 0.68% at a current of 1000 mA.

Under CW operation, the assembled device DEV_B exhibited an optical output of 11.4 mW and a maximum external quantum efficiency of 1.44% at a current of 200 mA. Under pulse operation, the assembled device DEV_B exhibited an optical output of 51.0 mW and a maximum external quantum efficiency of 1.48% at a current of 1000 mA.

In the relationship between external quantum efficiency and emission wavelength disclosed in Non-Patent Document 4, the following values represent the highest reported levels:
Maximum external quantum efficiency: 1.44% at an emission wavelength of 236 nm (CW operation)
Maximum external quantum efficiency: 0.59% at an emission wavelength of 230 nm (CW operation)

Furthermore, cathodoluminescence (CL) evaluation of the light-emitting layer of the LED structure was performed under an accelerating voltage of 2 kV.

The epitaxial structure used for CL evaluation was as follows. On a template including a sapphire substrate and an FFA-grown sapphire AlN template layer (thickness: 600 nm), an AlN film (thickness: 200 nm), a compositionally graded AlGaN layer (thickness: 100 nm), an n-type Al_{0.86}Ga_{0.14}N layer (thickness: 750 nm), and a light-emitting layer were sequentially grown by MOVPE. The light-emitting layer was formed either as a multiple quantum well (MQW) structure comprising seven well layers of 2 nm-thick Al_{0.79}Ga_{0.21}N and barrier layers of 3 nm-thick Al_{0.86}Ga_{0.14}N, or as a bulk Al_{0.79}Ga_{0.21}N film, for example, 35 nm thick.

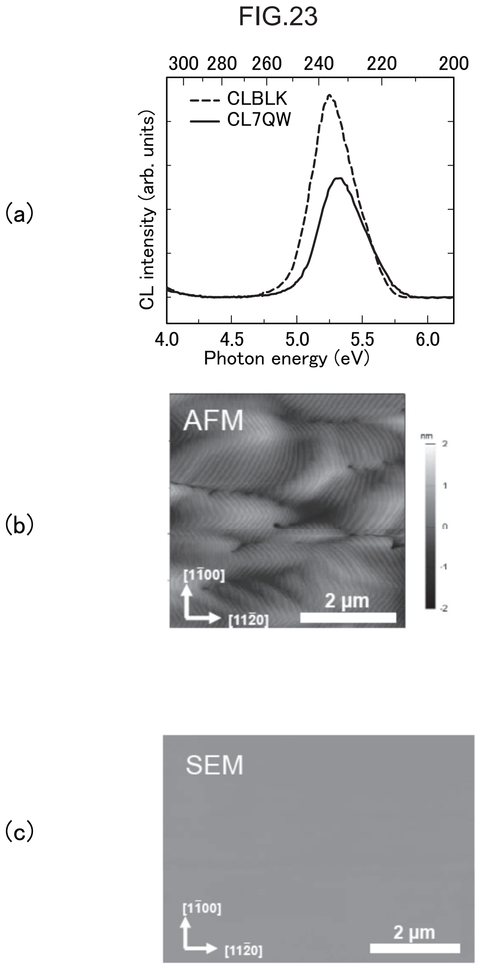

FIGS. 23A, 23B, and 23C respectively show the area-averaged CL spectrum, the atomic force microscope (AFM) surface image, and the scanning electron microscope (SEM) image, all measured at room temperature. Referring to FIG. 23A, CL spectra of the multiple quantum well light-emitting layer and the bulk light-emitting layer are shown. Analysis of the band-edge emission using a single Gaussian fit indicates a peak wavelength of approximately 235 nm. The peak intensity of the CL spectrum of the bulk light-emitting layer is greater than that of the multiple quantum well light-emitting layer.

Referring to FIGS. 23B and 23C, the AFM surface image of the bulk light-emitting layer shows irregularities on the surface, whereas the SEM image does not reveal any surface irregularities.

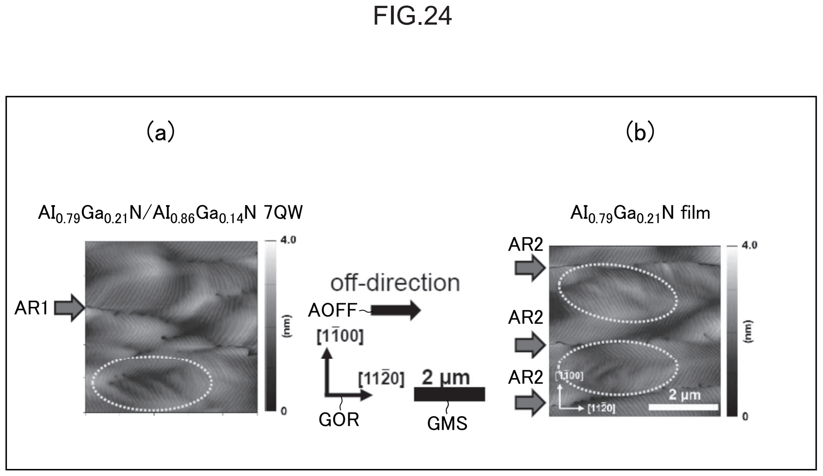

FIG. 24 shows AFM surface images of the light-emitting layers of the multiple quantum well structure and the bulk film. The arrow AOFF, the crystal orientation reference GOR, and the measurement scale GMS (2 µm in length) shown in FIG. 24 are common to parts (a) and (b) of FIG. 24.

Referring to part (a) of FIG. 24, steps of the template member appear in the off-direction (arrow AOFF) in the AFM surface image of the light-emitting layer having the multiple quantum well structure. The dashed-line box in part (a) of FIG. 24 indicates a region in which the surface film thickness fluctuates. Arrow AR1 indicates a recess between adjacent steps. Referring to part (b) of FIG. 24, steps of the template member also appear in the off-direction (arrow AOFF) in the AFM surface image of the bulk film light-emitting layer. The dashed-line box in part (b) of FIG. 24 indicates a region in which the surface film thickness fluctuates. Arrow AR2 indicates a recess between adjacent steps.

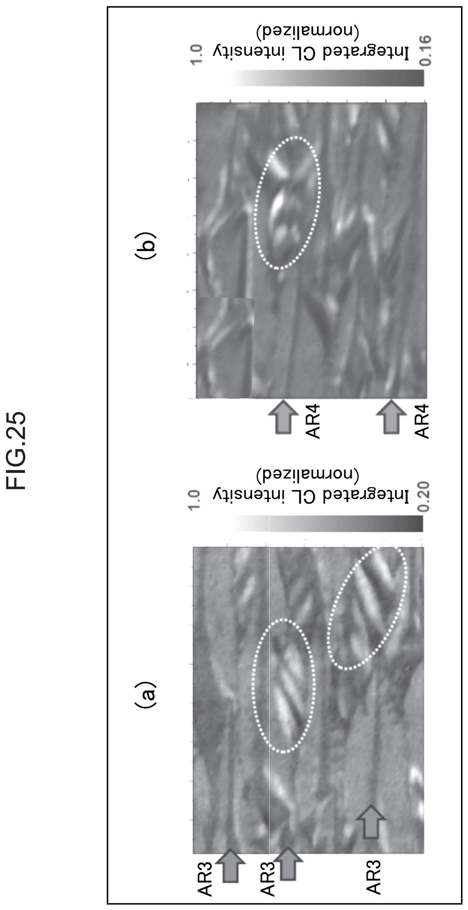

FIG. 25 shows CL images of the light-emitting layers of the multiple quantum well structure and the bulk film. The CL images are normalized to the intensity scale shown on the right side of parts (a) and (b) of FIG. 25.

Referring to part (a) of FIG. 25, a step-like pattern appears in the CL image of the light-emitting layer having the multiple quantum well structure in the off-direction of the template member (arrow AOFF in FIG. 24). The dashed-line box in part (a) of FIG. 25 indicates a region of high CL intensity. Arrow AR3 indicates a dark line. Referring to part (b) of FIG. 25, a step-like pattern also appears in the CL image of the bulk film light-emitting layer in the off-direction of the template member (arrow AOFF). The dashed-line box in part (b) of FIG. 25 indicates a region of high CL intensity. Arrow AR4 indicates a dark line.

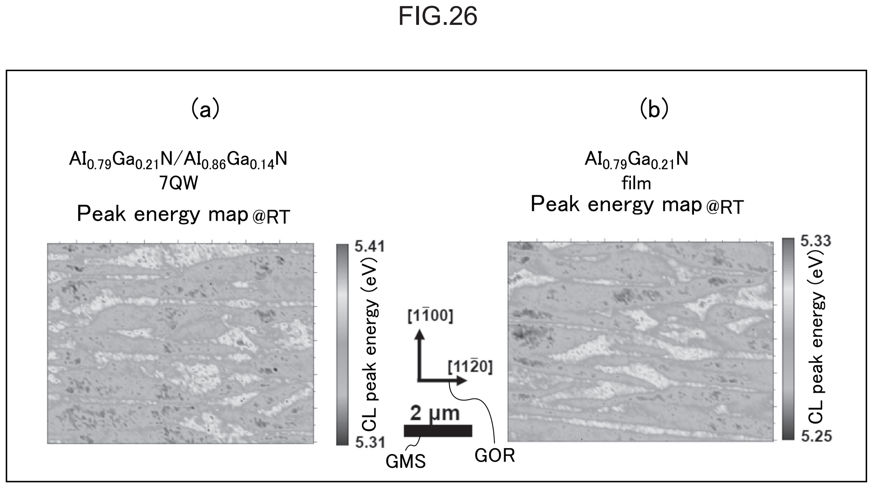

FIG. 26 shows CL peak energy maps of the light-emitting layers of the multiple quantum well structure and the bulk film. The crystal orientation system (GOR) and the measurement scale (GMS, 2 µm) shown in FIG. 26 are common to parts (a) and (b) of FIG. 26. The CL peak energy maps are normalized to the intensity scale shown on the right side of parts (a) and (b) of FIG. 26.

Referring to part (a) of FIG. 26, the CL peak energy map of the light-emitting layer having the multiple quantum well structure shows a streak-like region of high peak energy extending in the off-direction of the template member (arrow AOFF in FIG. 24). Referring to part (b) of FIG. 26, the CL peak energy map of the bulk film light-emitting layer also shows a streak-like region of high peak energy extending in the off-direction of the template member (arrow AOFF in FIG. 24).

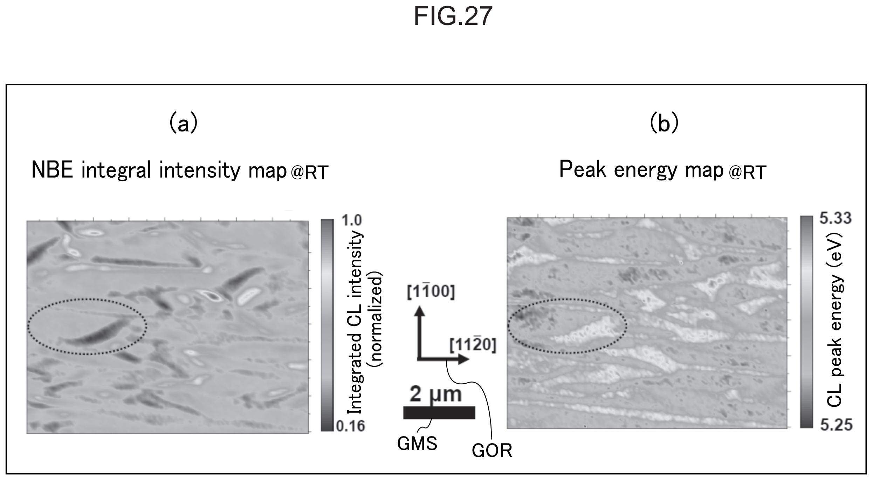

FIG. 27 shows the NBE integrated CL intensity map and the peak energy map of the bulk film light-emitting layer measured at room temperature. The crystal orientation system (GOR) and the measurement scale (GMS, 2 µm) shown in FIG. 27 are common to parts (a) and (b) of FIG. 27.

The CL images in parts (a) and (b) of FIG. 27 exhibit emission distributions that strongly reflect the off-axis orientation of the template layer surface. The CL images tend to show high CL intensity at low acceleration energies. The dashed-line boxes in parts (a) and (b) of FIG. 27 indicate regions where the CL intensity is high in the low-energy range. The maximum width of the CL peak energy within the dashed-line region is approximately 80 meV, which corresponds to a difference in Al composition of about 0.03. The AlN template layer has a stepped morphology, with step structures approximately 2 to 3 µm wide on the epitaxial surface associated with the off-axis orientation. Slight perturbations in the step structure of the epitaxial surface associated with the off-axis orientation cause variations in Al composition. The emission area corresponds to a Ga-rich region of the emission layer (i.e., a region where the Ga content is higher by up to approximately 0.03). Approximately 65% of the total optical emission intensity originates from the Ga-rich region rather than the Al-rich region. The optical transition level in the Ga-rich region differs from that in the Al-rich region by up to 30 meV.

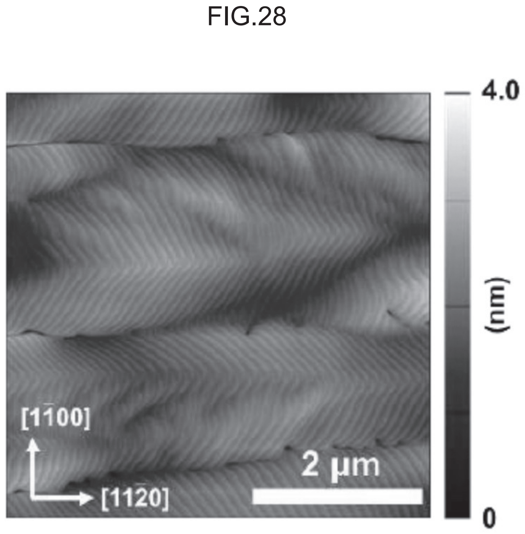

FIG. 28 shows the surface morphology observed in an AFM image. The right side of FIG. 28 shows the depth scale. The AFM image indicates that nanometer-scale surface irregularities on the growth surface cause slight compositional fluctuations of Group III elements.

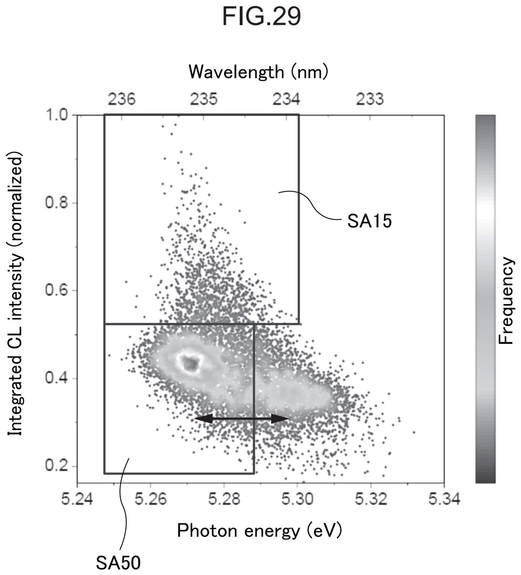

FIG. 29 shows the relationship between the integrated CL intensity and photon energy. The integrated CL intensity exhibits a peak at low photon energy, for example, around 5.27 eV, and tails off by approximately 30 meV toward the higher photon energy region. This tailing behavior indicates fluctuations in the Ga composition. Region SA15 represents an area with high CL intensity (15%) at the mapping point, and region SA50 represents an area with average CL intensity (50%) at the mapping point. These results indicate that weak localized emission accounts for approximately 65% of the total emission.

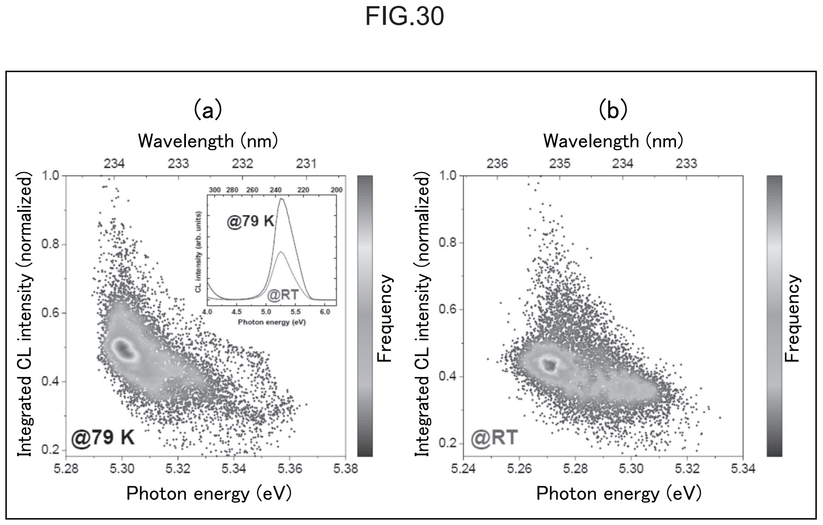

FIG. 30 shows the relationship between integrated CL intensity and photon energy measured at an absolute temperature of 79 K and at room temperature. Part (a) of FIG. 30 shows the integrated CL intensity distribution measured at 79 K, and part (b) of FIG. 30 shows the distribution measured at room temperature. A frequency scale is shown to the right of each integrated CL intensity distribution.

As shown in part (a) of FIG. 30, the integrated CL peak intensity at 79 K is greater than that at room temperature. At low temperatures, localized light emission occurs in the Ga-rich region, and this emission exhibits strong intensity.

The template member 112c and the active layer 114 are arranged along the axis Ax1. The Al_{Y}Ga_{1-Y}N layer exhibits fluctuations in Group III composition. The Al_{Y}Ga_{1-Y}N layer (where Y represents the average Al composition) includes Ga-rich and Al-rich regions in a reference plane intersecting the axis Ax1. The Ga-rich region contains a greater number of Ga atoms per unit volume than the Ga composition (1-Y), and the Al-rich region contains a greater number of Al atoms per unit volume than the Al composition Y. The Al composition Y of the Al_{Y}Ga_{1-Y}N layer varies by at least 0.03. The support 118 of the template member 112c is made of sapphire. The primary surface of the support 118 is off-axis in the m-axis direction, and the template layer 120 is oriented along the c-axis. The template layer 120 includes a hexagonal AlN layer. The surface of the template layer 120 has a step structure associated with the m-axis direction.

As described above, according to this embodiment, it is possible to provide a Group III nitride light-emitting device that suppresses a reduction in external quantum efficiency caused by a decrease in the band offset between the active layer and the electron blocking layer.

Several aspects of the present disclosure will be described below.

A Group III nitride light-emitting devices of the first aspect according to the present disclosure comprises: a Group III nitride semiconductor layer containing Al as a constituent element; an electron blocking layer containing Al as a constituent element; an active layer disposed between the electron blocking layer and the Group III nitride semiconductor layer so as to generate light having a peak wavelength in a deep ultraviolet wavelength region of 240 nm or less and 206 nm or more, the active layer including an Al_{Y}G_{1-Y}N layer, where Y is an Al composition, and Y is greater than zero; and a base member having a primary surface containing Al_{X}G_{1-X}N, the Group III nitride semiconductor layer, the active layer, and the electron blocking layer being mounted on the primary surface, wherein X is greater than 0 and 1 or less, wherein the active layer has an Al composition G of equal to or greater than Y and less than (Y + 0.04); and wherein a composition difference between a maximum Al composition of the electron blocking layer and an Al composition of the active layer is 0.18 or more.

In the III nitride light-emitting device of the second aspect according to the first aspect, the base member includes a template member, the template member includes a template layer and a support having a major surface made of a material that is different from a group III nitride, the template layer is made of the Al_{X}G_{1-X}N, and the Al_{X}G_{1-X}N includes compressive strain covering the major surface of the support, and has a (10-12) X-ray rocking curve half-width of 1000 arcsec or less.

In the III nitride light-emitting device of the third aspect according to the first aspect, the base member includes a bulk AlN single crystal substrate.

**In** the **III** nitride light-emitting device of the fourth aspect according to any one aspect of the first to third aspects, a maximum composition difference between an Al composition of the Group III nitride semiconductor layer and the Al composition of the Al_{Y}G_{1-Y}N layer is 0.06 or more.

In the III nitride light-emitting device of the fifth aspect according to any one aspect of the first to fourth aspects, the active layer includes the Al_{Y}G_{1-Y}N layer as one of the bulk light-emitting layer and a well layer of a quantum well structure.

In the III nitride light-emitting device of the six aspect according to the fifth aspect, the active layer includes the Al_{Y}G_{1-Y}N layer as the well layer of the quantum well structure, and a composition difference between the maximum Al composition of the electron blocking layer and an Al composition of a barrier layer of the quantum well structure is 0.18 or more.

In the III nitride light-emitting device of the seventh aspect according to any one aspect of the first to sixth aspects, the Al_{Y}G_{1-Y}N layer is in contact with the electron blocking layer.

In the III nitride light-emitting device of the eighth aspect according to the fifth aspect, the Al composition G of the active layer is substantially equal to Y over the active layer, and a composition difference between the maximum Al composition of the electron blocking layer and the Al compositions of the Al_{Y}G_{1-Y}N layer is 0.18 or more.

In the III nitride light-emitting device of the nineth aspect according to any one aspect of the first to sixth aspects,
the active layer includes a stacked structure having a plurality of semiconductor layers of different Al compositions, the plurality of semiconductor layers include at least one first semiconductor layer having a smallest Al composition among the Al compositions of the plurality of semiconductor layers, and at least one second semiconductor layer having a largest Al composition among the Al compositions of the plurality of semiconductor layers, the first semiconductor layer and the second semiconductor layer are arranged in a direction from one of the Group III nitride semiconductor layer and the electron blocking layer to the other, the first semiconductor layer includes the Al_{Y}G_{1-Y}N layer, the difference between the Al composition of the second semiconductor layer and the maximum Al composition of the electron blocking layer is greater than the difference between the Al composition of the first semiconductor layer and the Al composition of the second semiconductor layer, and the composition difference between the maximum Al composition of the electron blocking layer and the Al composition of the second semiconductor layer is 0.18 or more.

In the III nitride light-emitting device of the tenth aspect according to the nineth aspect, an Al composition of the Group III nitride semiconductor layer is greater than the Al composition of the second semiconductor layer, and a composition difference between the Al composition of the Group III nitride semiconductor layer and the Al composition of the second semiconductor layer is larger than a composition difference between the Al composition of the first semiconductor layer and the Al composition of the second semiconductor layer.

In the III nitride light-emitting device of the eleventh aspect according to the nineth or tenth aspect, the Al composition difference between the Al composition of the second semiconductor layer and the Al composition of the first semiconductor layer is less than 0.04.

In the III nitride light-emitting device of the twelfth aspect according to the eleventh aspect, the Al composition difference between the Al composition of the first semiconductor layer and the Al composition of the second semiconductor layer is less than 0.01.

In the III nitride light-emitting device of the thirteenth aspect according to any one aspect of the nineth to twelfth aspects, the Al composition of the second semiconductor layer is less than 0.823 and greater than Y.

In the III nitride light-emitting device of the fourteenth aspect according to the thirteenth aspect, the Al composition of the second semiconductor layer is equal to or less than 0.801.

In the III nitride light-emitting device of the fifteenth aspect according to any one aspect of the nineth to eleventh aspects, the stacked structure has a multiple quantum well structure, the multiple quantum well structure includes a plurality of well layers as the first semiconductor layer and at least one barrier layer as the second semiconductor layer, the barrier layer includes an Al_{Z}G_{1-Z}N layer (where Z of the Al composition is larger than Y), each of the well layers includes the Al_{Y}G_{1-Y}N layer, the barrier layer is closest to the electron blocking layer, a difference between an Al composition of the barrier layer and the maximum Al composition of the electron blocking layer is greater than the difference between the Al composition of the barrier layer and an Al composition of the well layer, and a difference in Al composition between the maximum Al composition of the electron blocking layer and the Al composition of the barrier layer is 0.18 or more.

In the III nitride light-emitting device of the sixteenth aspect according to the fifteenth aspect, the Al composition of the Group III nitride semiconductor layer is greater than the Al composition of the barrier layer, and an difference in Al composition between the Al composition of the Group III nitride semiconductor layer and the Al composition of the barrier layer is larger than the difference in Al composition between the Al composition of the well layer and the Al composition of the barrier layer.

**In** the **III** nitride light-emitting device of the seventeenth aspect according to the fifteenth or sixteenth aspect, the difference in Al composition between the Al composition of the well layer and the Al composition of the barrier layer is less than 0.04.

In the III nitride light-emitting device of the eighteenth aspect according to the seventeenth aspect, the difference in Al composition between the Al composition of the well layer and the Al composition of the barrier layer is less than 0.01.

In the III nitride light-emitting device of the nineteenth aspect according to any one aspect of the fifteenth to eighteenth aspects, the Al composition G in the multiple quantum well structure is greater than Y in the barrier layer and is (Y + 0.04) or more in the barrier layer.

In the III nitride light-emitting device of the 20th aspect according to any one aspect of the fifteenth to nineteenth aspects, the Al composition of the barrier layer is less than 0.823 and greater than Y.

In the III nitride light-emitting device of the 21th aspect according to any one aspect of the fifteenth to nineteenth aspects, the Al composition of the barrier layer is equal to or less than 0.801.

In the III nitride light-emitting device of the 22th aspect according to any one aspect of the nineth to fourteenth aspects, the Al composition of the first semiconductor layer, the Al composition of the second semiconductor layer, a thickness of the first semiconductor layer, a thickness of the second semiconductor layer, and an arrangement of the first semiconductor layer and the second semiconductor layer are determined such that a quantum well structure is not formed therefrom in the active layer.

In the III nitride light-emitting device of the 23th aspect according to the 22th aspect, the Al composition G in the stacked structure is greater than Y and less than (Y + 0.04) in the second semiconductor layer.

In the III nitride light-emitting device of the 24th aspect according to any one aspect of the fifteenth to 23th aspects, the Al composition of the first semiconductor layer, the Al composition of the second semiconductor layer, a thickness of the first semiconductor layer, a thickness of the second semiconductor layer, and an arrangement of the first semiconductor layer and the second semiconductor layer are determined such that a quantum well structure is formed therefrom in the active layer.

In the III nitride light-emitting device of the 25th aspect according to any one aspect of the first to 24th aspects, the Group III nitride semiconductor layer includes an Al_{W}G_{1-W}N layer, where W is less than 1 and greater than 0, and an Al composition W of the Group III nitride semiconductor layer is 0.85 or more.

In the III nitride light-emitting device of the 26th aspect according to the second aspect, the template member and the active layer are arranged in the direction of a first axis, the Al_{Y}G_{1-Y}N layer has fluctuations in group III composition, the Al_{Y}G_{1-Y}the N layer of the active layer includes a Ga-rich region and an Al-rich region arranged in a reference plane intersecting the first axis, the Ga-rich region contains more Ga atoms per unit volume than the Ga composition of (1-Y), and the Al-rich region contains more Al atoms per unit volume than the Al composition of Y.

In the III nitride light-emitting device of the 27th aspect according to the 26th aspect, the Al-rich region has a deviation of at least 0.03 relative to the Al composition Y of the Al_{Y}Ga_{1-Y}N layer.

The invention is not limited to the above-described embodiments, and can be implemented in various ways without departing from the scope of the invention. Then, they are all included in the technical concept of the present invention.

This application claims the priority of Japanese Patent Application No. 2023-091229, filed on June 1, 2023, the entire contents of which are incorporated herein by reference.

## Claims

1. A Group III nitride light-emitting device comprising:
a Group III nitride semiconductor layer containing Al as a constituent element;
an electron blocking layer containing Al as a constituent element;
an active layer disposed between the electron blocking layer and the Group III nitride semiconductor layer so as to generate light having a peak wavelength in a deep ultraviolet wavelength region of 240 nm or less and 206 nm or more, the active layer including an Al_{Y}G_{1-Y}N layer, where Y is an Al composition, and Y is greater than zero; and
a base member having a primary surface containing Al_{X}G_{1-X}N, the Group III nitride semiconductor layer, the active layer, and the electron blocking layer being mounted on the primary surface, wherein X is greater than 0 and 1 or less,
wherein the active layer has an Al composition G of equal to or greater than Y and less than (Y + 0.04); and
wherein a composition difference between a maximum Al composition of the electron blocking layer and an Al composition of the active layer is 0.18 or more.

2. The Group III nitride light-emitting device according to claim 1, wherein
the base member includes a template member,
the template member includes a template layer and a support having a major surface made of a material that is different from a group III nitride,
the template layer is made of the Al_{X}G_{1-X}N, and
the Al_{X}G_{1-X}N includes compressive strain covering the major surface of the support, and has a (10-12) X-ray rocking curve half-width of 1000 arcsec or less.

3. The group III nitride light-emitting device according to claim 1,
wherein the base member includes a bulk AlN single crystal substrate.

4. The group III nitride light-emitting device according to any one of claims 1 to 3,
wherein a maximum composition difference between an Al composition of the group III nitride semiconductor layer and the Al composition of the Al_{Y}G_{1-Y}N layer is 0.06 or more.

5. The group III nitride light-emitting device according to any one of claims 1 to 4,
wherein the active layer includes the Al_{Y}G_{1-Y}N layer as one of the bulk light-emitting layer and a well layer of a quantum well structure.

6. The group III nitride light-emitting device according to claim 5,
wherein the active layer includes the Al_{Y}G_{1-Y}N layer as the well layer of the quantum well structure, and
wherein a composition difference between the maximum Al composition of the electron blocking layer and an Al composition of a barrier layer of the quantum well structure is 0.18 or more.

7. The group III nitride light-emitting device according to any one of claims 1 to 6,
wherein the Al_{Y}G_{1-Y}N layer is in contact with the electron blocking layer.

8. The group III nitride light-emitting device according to claim 5,
wherein the Al composition G of the active layer is substantially equal to Y over the active layer, and
wherein a composition difference between the maximum Al composition of the electron blocking layer and the Al compositions of the Al_{Y}G_{1-Y}N layer is 0.18 or more.

9. The group III nitride light-emitting device according to any one of claims 1 to 6,
wherein the active layer includes a stacked structure having a plurality of semiconductor layers of different Al compositions,
wherein the plurality of semiconductor layers include at least one first semiconductor layer having a smallest Al composition among the Al compositions of the plurality of semiconductor layers, and at least one second semiconductor layer having a largest Al composition among the Al compositions of the plurality of semiconductor layers,
wherein the at least one first semiconductor layer and the at least one second semiconductor layer are arranged in a direction from one of the group III nitride semiconductor layer and the electron blocking layer to the other,
wherein the at least one first semiconductor layer includes the Al_{Y}G_{1-Y}N layer,
wherein the difference between the Al composition of the at least one second semiconductor layer and the maximum Al composition of the electron blocking layer is greater than the difference between the Al composition of the at least one first semiconductor layer and the Al composition of the at least one second semiconductor layer, and
wherein a composition difference between the maximum Al composition of the electron blocking layer and the Al composition of the at least one second semiconductor layer is 0.18 or more.

10. The group III nitride light-emitting device according to claim 9,
wherein an Al composition of the group III nitride semiconductor layer is greater than the Al composition of the at least one second semiconductor layer, and
wherein a difference between the Al composition of the group III nitride semiconductor layer and the Al composition of the at least one second semiconductor layer is larger than the difference between the Al composition of the at least one first semiconductor layer and the Al composition of the at least one second semiconductor layer.

11. The group III nitride light-emitting device according to claim 9 or 10,
wherein the Al composition difference between the Al composition of the at least one second semiconductor layer and the Al composition of the at least one first semiconductor layer is less than 0.04.

12. The group III nitride light-emitting device according to claim 11,
wherein the difference between the Al composition of the at least one first semiconductor layer and the Al composition of the at least one second semiconductor layer is less than 0.01.

13. The group III nitride light-emitting device according to any one of claims 9 to 12,
wherein the Al composition of the at least one second semiconductor layer is less than 0.823 and greater than Y.

14. The group III nitride light-emitting device according to claim 13,
wherein the Al composition of the at least one second semiconductor layer is equal to or less than 0.801.

15. The group III nitride light-emitting device according to any one of claims 9 to 14,
wherein the stacked structure has a multiple quantum well structure,
wherein the multiple quantum well structure includes a plurality of well layers as the at least one first semiconductor layer and at least one barrier layer as the at least one second semiconductor layer,
wherein the barrier layer includes an Al_{Z}G_{1-Z}N layer (where Z of the Al composition is larger than Y),
wherein each of the well layers includes the Al_{Y}G_{1-Y}N layer,
wherein the barrier layer is closest to the electron blocking layer,
wherein a difference between an Al composition of the barrier layer and the maximum Al composition of the electron blocking layer is greater than the difference between the Al composition of the barrier layer and an Al composition of the well layer, and
wherein a difference in Al composition between the maximum Al composition of the electron blocking layer and the Al composition of the barrier layer is 0.18 or more.

16. The group III nitride light-emitting device according to claim 15,
wherein the Al composition of the group III nitride semiconductor layer is greater than the Al composition of the barrier layer, and
wherein a difference in Al composition between the Al composition of the group III nitride semiconductor layer and the Al composition of the barrier layer is larger than a difference in Al composition between the Al composition of the well layer and the Al composition of the barrier layer.

17. The group III nitride light-emitting device according to claim 15 or 16,
wherein a difference in Al composition between the Al composition of the well layer and the Al composition of the barrier layer is less than 0.04.

18. The group III nitride light-emitting device according to claim 17,
wherein the difference in Al composition between the Al composition of the well layer and the Al composition of the barrier layer is less than 0.01.

19. The group III nitride light-emitting device according to any one of claims 15 to 18,
wherein the Al composition G in the multiple quantum well structure is greater than Y in the barrier layer and is (Y + 0.04) or more in the barrier layer.

20. The group III nitride light-emitting device according to any one of claims 15 to 19,
wherein the Al composition of the barrier layer is less than 0.823 and greater than Y.

21. The group III nitride light-emitting device according to claim 20,
wherein the Al composition of the barrier layer is equal to or less than 0.801.

22. The group III nitride light-emitting device according to any one of claims 9 to 14,
wherein the Al composition of the at least one first semiconductor layer, the Al composition of the at least one second semiconductor layer, a thickness of the at least one first semiconductor layer, a thickness of the at least one second semiconductor layer, and an arrangement of the at least one first semiconductor layer and the at least one second semiconductor layer are determined such that a quantum well structure is not formed therefrom in the active layer.

23. The group III nitride light-emitting device according to claim 22,
wherein the Al composition G in the stacked structure is greater than Y and less than (Y + 0.04) in the at least one second semiconductor layer.

24. The group III nitride light-emitting device according to any one of claims 15 to 23,
wherein the Al composition of the at least one first semiconductor layer, the Al composition of the at least one second semiconductor layer, a thickness of the at least one first semiconductor layer, a thickness of the at least one second semiconductor layer, and an arrangement of the at least one first semiconductor layer and the at least one second semiconductor layer are determined such that a quantum well structure is formed therefrom in the active layer.

25. The group III nitride light-emitting device according to any one of claims 1 to 24,
wherein the group III nitride semiconductor layer includes an Al_{W}G_{1-W}N layer, where W is less than 1 and greater than 0, and
wherein an Al composition W of the group III nitride semiconductor layer is 0.85 or more.

26. The group III nitride light-emitting device according to claim 2,
wherein the template member and the active layer are arranged in the direction of a first axis,
wherein the Al_{Y}G_{1-Y}N layer has fluctuations in group III composition,
wherein the Al_{Y}G_{1-Y}the N layer of the active layer includes a Ga-rich region and an Al-rich region arranged in a reference plane intersecting the first axis,
wherein the Ga-rich region contains more Ga atoms per unit volume than the Ga composition of (1-Y), and
wherein the Al-rich region contains more Al atoms per unit volume than the Al composition of Y.

27. The group III nitride light-emitting device according to claim 26, wherein the Al-rich region has a deviation of at least 0.03 relative to the Al composition Y of the Al_{Y}Ga_{1-Y}N layer.
